Europäisches Patentamt

European Patent Office

Office européen des brevets

(19)

(11) **EP 1 269 213 B1**

(12) **EUROPÄISCHE PATENTSCHRIFT**

(45) Veröffentlichungstag und Bekanntmachung des Hinweises auf die Patenterteilung:
**09.06.2004 Patentblatt 2004/24**

(51) Int Cl.$^7$: **G01R 33/60**

(21) Anmeldenummer: 01911706.8

(22) Anmeldetag: **28.02.2001**

(86) Internationale Anmeldenummer:
**PCT/EP2001/002248**

(87) Internationale Veröffentlichungsnummer:
**WO 2001/065270 (07.09.2001 Gazette 2001/36)**

(54) **VERFAHREN ZUR ESR-SPEKTROSKOPISCHEN BESTIMMUNG VON VERÄNDERUNGEN DER TRANSPORTEIGENSCHAFTEN DES ALBUMINS IN EINER ALBUMINHALTIGEN PROBE**

METHOD FOR THE ESR-SPECTROSCOPIC DETECTION OF CHANGES IN THE TRANSPORT PROPERTIES OF ALBUMIN IN AN ALBUMIN-CONTAINING SAMPLE

PROCEDE DE DETERMINATION SPECTROSCOPIQUE ESR DE MODIFICATIONS DES PROPRIETES DE TRANSPORT DE L'ALBUMINE DANS UN ECHANTILLON CONTENANT DE L'ALBUMINE

(84) Benannte Vertragsstaaten:
**AT BE CH CY DE DK ES FI FR GB GR IE IT LI LU MC NL PT SE TR**

(30) Priorität: **28.02.2000 DE 10011163**

(43) Veröffentlichungstag der Anmeldung:
**02.01.2003 Patentblatt 2003/01**

(73) Patentinhaber: **E.W. Handels- und Consulting GmbH**
**15732 Eichwalde (DE)**

(72) Erfinder:
• **MURAVSKY, Vladimir, A.**
**220040 Minsk (BY)**
• **MILUTIN, Alexander**
**220075 Minsk (BY)**
• **MATTHES, Gert, A.**
**10117 Berlin (DE)**
• **SEIBT, Günter**
**15732 Eichwalde (DE)**

(74) Vertreter: **Ziebig, Marlene, Dr. Dipl.-Chem. et al**
**Patentanwälte**
**Gulde Hengelhaupt Ziebig & Schneider**
**Schützenstrasse 15-17**
**10117 Berlin (DE)**

(56) Entgegenhaltungen:
**EP-A- 0 570 592      EP-A- 0 973 043**
**WO-A-96/21867      US-A- 5 629 625**

• GANTCHEV TSVETAN G ET AL: "Binding interactions and conformational changes induced by sulfonated aluminum phthalocyanines in human serum albumin." ARCHIVES OF BIOCHEMISTRY AND BIOPHYSICS, Bd. 366, Nr. 1, 1. Juni 1999 (1999-06-01), Seiten 21-30, XP001005397 ISSN: 0003-9861
• RYZHOV V A ET AL: "SPECTROMETER FOR STUDYING BROAD MAGNETIC DIPOLE TRANSITIONS IN MAGNETS AND THE HALL CONDUCTIVITY AT MICROWAVE FREQUENCIES IN CONDUCTING MATERIALS" SOVIET PHYSICS TECHNICAL PHYSICS, AMERICAN INSTITUTE OF PHYSICS. NEW YORK, US, Bd. 40, Nr. 1, 1995, Seiten 71-77, XP000497081

**Beschreibung**

Die Erfindung betrifft ein in der medizinischen, biologischen, biotechnologischen und veterinärmedizinischen Praxis anwendbares Verfahren zur ElektronenSpinResonanz (ESR)-spektroskopischen Bestimmung von Veränderungen der Transporteigenschaften des Albumins in einer albuminhaltigen Probe, das zur Diagnose und/oder Überwachung physiologischer oder pathologischer Veränderungen im menschlichen oder tierischen Körper oder zur Qualitätskontrolle von albuminhaltigen Präparaten, insbesondere Blutprodukten, eingesetzt werden kann. Gegenstand der Erfindung ist auch die Verwendung eines ESR-Spektrometers zur Durchführung des erfindungsgemäßen Verfahrens.

Es ist bekannt, zur Diagnose von Krankheiten hämatologische Parameter oder Parameter betreffend Antigene, Hormone, Enzyme und andere biologisch aktive Substanzen heranzuziehen, was in der klinisch-chemischen Routinediagnostik breite Anwendung findet.

Auch die NMR- und die ESR-Spektroskopie können in der Krankheitsdiagnostik zur Erfassung struktureller und funktioneller Eigenschaften von Protein- und Lipidkomponenten im Blutserum eingesetzt werden. Obwohl die Anwendung der ESR-Spektroskopie unter Einsatz von Spinlabels zur Untersuchung von Bewegungsvorgängen in Makromolekülen bekannten Stand der Technik darstellt, scheiterte die breite Einführung dieser Testmethode in die klinische Routinediagnostik bisher an den hohen Ausrüstungskosten und an der komplizierten oder nicht zuverlässigen Analyse der Signale.

SU 1319705 A1 beschreibt ein Verfahren zur Diagnose von bösartigen Erkrankungen, indem mittels ESR die Fähigkeit des Blutplasmas oder Blutserums gemessen wird, eine eingebrachte Spinsonde zu binden. Es wird der Bindungskoeffizient $\alpha$, der das Verhältnis der Amplitude des Peaks A zur Amplitude des Peaks B darstellt, bestimmt. Ist $\alpha > 1$, so handelt es sich um eine cancerogene Erkrankung. Bei $\alpha < 1$ ist der Proband gesund.

Das beschriebene Verfahren hat den Nachteil, daß es nicht sensitiv genug arbeitet und deshalb keine zuverlässige Diagnose liefern kann. Untersuchungen zu dieser Methode haben gezeigt, daß die falsch-positiven und falschnegativen Diagnoseaussagen im frühen Krankheitsstadium $\geq 30\%$ betragen.

EP 0 973 043 A1 beschreibt ein ESR-spektroskopisches Verfahren zur Diagnose von malignen Neoplasmen im Blutserum, bei dem physiko-chemische Parameter der Spinsondenmobilität einer Spinsonde, die eine spinmarkierte Fettsäure darstellt, in den drei Bindungstellen des Albumins bestimmt werden.

Albumin ist die Hauptkomponente im Transportsystem des Blutes, die den Transport von Fettsäuren, Tryptophan, Bilirubin, Kalzium, Steroidhormonen und anderen funktionell wichtigen Wirkstoffen an die Zielzelle ermöglicht und dabei an der Bindung und Verteilung einer Vielzahl von Toxinen (darunter auch endogenen Ursprungs) beteiligt ist. Albumin ist ein Polypeptid (Molekulargewicht 68.000) mit einer großen Bindungskapazität für exogene (Arzneimittel) und endogene Substanzen. Es besteht aus 585 Aminosäuren, die durch Disulfidbrücken in einer Schleifenstruktur angeordnet sind. In der Literatur werden verschiedene Bindungsstellen am Serumalbumin unterschieden. Für Fettsäuren existieren die sogenannten Bindungsstellen 1, 2 und 3 im Albuminmolekül.

Beim Diagnoseverfahren gemäß EP 0 973 043 A1 wird die Krebserkrankung durch die Abweichung der Parameter der Spinsondenbindung von den Werten bestimmt, die gesunde Probanden aufweisen.

Mit dem ESR-Verfahren gemäß EP 0 973 043 A1 wird also der konkrete native Konformationszustand des Albumins im Blut bestimmt, der bei Vorliegen eines cancerogenen Befundes verändert gegenüber dem eines gesunden Probanden ist. Es hat sich gezeigt, daß dieses Verfahren falsch-positive oder falsch-negative Aussagen liefert, wenn zusätzliche Einflüsse aus dem Blut auf das Albumin vorhanden sind, z.B. erhöhte Blutfettwerte, Medikamenteneinnahme oder Einflüsse vom Lösungsmittel der Spinsonde oder durch Aufbewahrung der Blutprobe an der Luft.

Es ist die Aufgabe der vorliegenden Erfindung, ein kostengünstiges und schnell durchführbares Verfahren zur ESR-spektroskopischen Bestimmung von albuminhaltigen Proben, insbesondere Blutproben, bereitzustellen, das richtige und reproduzierbare Aussagen zur Konformation des Albumins unter Berücksichtigung der genannten Einflüsse erlaubt und in der klinisch-chemischen Laborpraxis anwendbar ist. Das Verfahren soll zur frühzeitigen Diagnose und/oder Überwachung physiologischer oder pathologischer Veränderungen im menschlichen oder tierischen Körper, zur Qualitätskontrolle albuminhaltiger Materialien, insbesondere von Blutkonserven, und zur Beurteilung der Detoxifikationskapazität von Albuminmolekülen geeignet sein.

Die Aufgabe der Erfindung wird gelöst, indem die Veränderungen der Transporteigenschaften des Albumins in der zu untersuchenden Probe mittels ESR-Spektroskopie bestimmt werden, indem in der zu untersuchenden Probe gezielte Konformationsänderungen des Albuminmoleküls mittels eines polaren Reagenzes unter Zusatz einer geeigneten Spinsonde induziert werden. Es hat sich gezeigt, daß die mittels ESR bestimmbaren Parameter der Bindung einer Spinsonde an spezifische, bekannte Bindungsstellen des Albumins mit biophysikalischen Parametern der Albuminkonformation korrelieren und letztere zuverlässige Aussagen über physiologische oder pathologische Veränderungen im menschlichen oder tierischen Körper oder auch in Präparaten der Transfusions- oder Transplantationsmedizin erlauben.

Erfindungsgemäß werden aliquoten Teilen der Probe mindestens drei, vorzugsweise bis zu acht, unterschiedliche Konzentrationen einer mit dem Albumin bindenden Spinsonde und zusätzlich mindestens drei, vorzugsweise bis zu acht, unterschiedliche Konzentrationen eines polaren Reagenzes zugesetzt, anhand der ESR-Spektren der mit Spinsonde und polarem Reagenz versetzten aliquoten Teile der Grad der Veränderung der Bindungsparameter der Spinsonde an spezifische Bindungsstellen des Albumins in Abhängigkeit von der Spinsondenkonzentration und der Konzentration an polarem Reagenz mittels computersimulation der ESR-Spektren bestimmt und die Veränderung der Transporteigenschaften des Albumins aus den Veränderungen der Werte der Bindungsparameter der Spinsonde für die durch die unterschiedlichen Konzentrationen an Spinsonde und polarem Reagenz induzierten Konformationszustände des Albumins berechnet, wobei die zuzusetzenden Konzentrationen an Spinsonde so ausgewählt werden, daß der Mittelwert des Verhältnisses der Konzentration der Spinsonde zur Konzentration des Albumins $2,5 \pm 0,5$ beträgt und ausgehend von diesem Mittelwert mindestens zwei zusätzliche Konzentrationen ausgewählt werden, deren Abweichung von diesem Mittelwert nicht geringer als 1,0 ist. Die zuzusetzenden Konzentrationen an polarem Reagenz werden so ausgewählt, daß der Mittelwert der Endkonzentration des polaren Reagenzes in den Aliquoten $(0,6 \pm 0,25)$ x Cp beträgt, wobei Cp die kritische Konzentration des polaren Reagenzes darstellt, dessen Überschreitung zur Denaturierung des Albumins führt, und ausgehend von diesem Mittelwert mindestens zwei zusätzliche Konzentrationen an polarem Reagenz ausgewählt werden, deren Abweichung von diesem Mittelwert mindestens 15% beträgt.

Dabei müssen die Konzentrationen an Spinsonde und polarem Reagenz, die den jeweiligen aliquoten Teilen der Probe zugesetzt werden, innerhalb der angegebenen Konzentrationsbereiche so gewählt werden, daß mindestens in einem aliquoten Teil eine geringe Sondenkonzentration und eine geringe Konzentration an polarem Reagenz, in mindestens einem aliquoten Teil eine hohe Sondenkonzentration und eine hohe Konzentration an polarem Reagenz und in mindestens einem aliquoten Teil eine mittlere Konzentration an polarem Reagenz und eine mittlere Konzentration Sonde vorhanden sind (3-Spektren-Screening-Analyse). Vorzugsweise können zusätzlich noch weitere Konzentrationen so gewählt werden, daß in mindestens einem aliquoten Teil eine hohe Sondenkonzentration und eine geringe Konzentration an polarem Reagenz vorhanden ist und besonders bevorzugt zusätzlich in mindestens einem aliquoten Teil eine geringe Sondenkonzentration und eine hohe Konzentration an polarem.

Reagenz vorhanden ist (8-Spektren-Analyse). Durch diese Konzentrationskombination wird sichergestellt, daß die Transporteigenschaften des Albumins in den verschiedenen Etappen erfaßt werden, nämlich der physiologische Zustand beim Binden hydrophober Verbindungen wie z.B. Fettsäuren (geringe Sondenkonzentration und geringe Konzentration an polarem Reagenz), der physiologische Zustand während des Transports hydrophober Verbindungen durch das vaskuläre System (hohe Sondenkonzentration und geringe Konzentration an polarem Reagenz) und der physiologische Zustand beim Abgeben (Entladen) hydrophober Verbindungen an die Zielzellen (hohe Sondenkonzentration und hohe Konzentration an polarem Reagenz).

Während gemäß SU 1319705 lediglich die Bestimmung des Bindungskoeffizienten des Blutplasmas oder Blutserums im nativen Zustand möglich ist und gemäß EP 0 973 043 A1 der konkrete native Zustand des Albumins in der zu untersuchenden Blutprobe bestimmt wird, erfaßt das erfindungsgemäße Verfahren Veränderungen der Albuminkonformation (Konformationsmobilität) in ihrem zeitlichen Verlauf unter dem Einfluß eines polaren Reagenzes und damit die Albuminfunktionalität und Veränderung der Bindungsparameter von Substraten an das Albumin. Da solche Veränderungen schon sehr frühzeitig z. B. durch pathologische Prozesse wie z. B. Krebsentstehung, durch eine medizinische Behandlung, durch Drogenabusus oder auch während der Fraktionierungsschritte von Blutplasmabestandteilen und bei inkorrekter Lagerung von Plasmaderivaten hervorgerufen werden, ist es erfindungsgemäß möglich, schon im frühen Stadium von Veränderungen der Albuminfunktionalität klare Diagnoseaussagen zu treffen. In Abhängigkeit von der physiko-chemischen Charakteristik des Mediums für die ESR-Analyse werden in den Blutproben die Albuminkonformation und dadurch auch die Bindungseigenschaften einer Reihe von Substraten am Albumin verändert.

Das erfindungsgemäße Verfahren ist also dadurch gekennzeichnet, daß mittels ESR-Spektroskopie Veränderungen der Transporteigenschaften des Albumins (die Albuminfunktionalität) z.B. im Blut bestimmt werden, indem gezielte Konformationsänderungen des Albuminmoleküls durch verschiedene Konzentrationen an polarem Reagenz in Gegenwart verschiedner Konzentrationen an Spinsonde hervorgerufen werden. Die von den aliquoten Teilen aufgezeichneten ESR-Spektren werden mittels eines mathematischen Modells, das vorzugsweise auf einer Hamilton-Funktion mit axialer Anisotropie basiert, elektronisch simuliert, die experimentellen und simulierten Spektren verglichen und Parameter der Spinsondenbindung an spezifischen Spinsondenbindungsstellen des Albumins elektronisch bestimmt, vorzugsweise durch Minimierung der Quadrate der Differenzen der Spektrenwerte der modellierten und der experimentell gemessenen ESR-Spektren, die diesen Bindungsstellen entsprechen, wobei die ermittelten Parameter der Spinsondenbindung mit biophysikalischen Parametern der Albuminkonformation korrelieren und je nach zu diagnostizierender physiologischer oder pathologischer Veränderung aus den ermittelten Parametern spezifische Parameter selektiert werden und aus diesen Parametern die cut-off-Werte als Entscheidungskriterium mittels einer Diskriminierungsfunktion für die spezifische Modifizierung der Albuminkonformation wie sie bei speziellen pathologischen oder physiologischen Veränderungen auftritt, elektronisch berechnet werden.

Erfindungsgemäß wird als Spinsonde eine Verbindung eingesetzt, die eine spezifische Bindung mit dem Albumin eingehen kann, insbesondere Fettsäuren, Steroidhormone oder heterocyclische Kohlenwasserstoffe, die spinmarkiert sein müssen. Auch hydrophobe Verbindungen, die mit Nitroxylradikalen als bekannten Spinsonden markiert sind, können im erfindungsgemäßen Verfahren Anwendung finden. In einer besonders bevorzugten Ausführungsform der Erfindung werden spin-markierte Fettsäuren als Spinsondeneingesetzt, bevorzugt Doxylstearinsäuren. Ganz besonders bevorzugt kommt 16-, 5-, 7- oder 12-Doxyl-Stearinsäure zur Anwendung. Werden spin-markierte Fettsäuren als Spinsonden eingesetzt, so können Parameter der Spinsondenbindung in den Bindungsstellen 1, 2 und 3 des Albumins bestimmt werden.

Als polares Reagenz kommt Alkohol oder DMSO in Frage, wobei vorzugsweise ein $C_1$-$C_6$-Alkohol eingesetzt wird, ganz besonders bevorzugt Ethylalkohol.

Als albuminhaltige Probe ist im Sinne der vorliegenden Erfindung z.B. eine Blutprobe oder eine albuminhaltige Arznemittel- oder Produktprobe zu verstehen.

Erfindungsgemäß werden die ESR-Spektren mit mindestens drei, vorzugsweise auch bis zu acht, Spinsondenkonzentrationen aufgezeichnet. Beispielsweise werden drei Aliqoten einer Serumprobe mit einem Volumen von je 50 μl mit 16-Doxyl-Stearinsäure in drei verschiedenen Konzentrationen und mit einem polaren Reagenz in drei verschiedenen Volumina versetzt, so daß die Endkonzentration der Spinsonde in den zu untersuchenden Aliquoten $8,33*10^{-4}$ mol/l, $1,55*10^{-3}$ mol/l und $2,41*10^{-3}$ mol/l und die Konzentration des polaren Reagenzes 2,90 mol/l, 3,37 mol/l und 3,80 mol/l beträgt (siehe Tabelle 1) .

Die Inkubationszeit beträgt von 7 bis 15 Minuten, vorzugsweise 10 Minuten. Bei der Inkubation sollte geschüttelt werden. Die ESR-Spektren werden in der Regel bei 37°C und dem physiologischen pH-Wert des Blutes aufgezeichnet. Zur Erhöhung der Präzision können die Spektren bei zwei oder mehr verschiedenen Temperaturwerten der Proben zwischen 15 und 45 °C und/oder bei zwei oder mehr verschiedenen pH-Werten der Serumproben von 7,5 bis 3,5 aufgezeichnet werden.

Die Analyse der gemessenen ESR-Spektren erfolgt elektronisch mit Hilfe einer speziell entwickelten Computersoftware für die Molekül-Mobilitäts-Struktur Analyse (MMS). Die auf der Basis der mindestens drei, vorzugsweise acht Aliquote einer albuminhaltigen Probe, vorzugsweise einer Serum- oder Plasmaprobe aufgezeichneten ESR-Spektren werden in die Computersoftware überführt, um die Parameter der Spinsondenbindung an den verschiedenen Typen der Bindungsstellen zu berechnen. Die Parameter der Spinsondenbindungen werden auf der Basis einer ESR-Spektrensimulation analysiert. Ein ESR-Spektrenmodell, vorzugsweise basierend auf einer Hamilton-Funktion mit axialer Anisotropie, wird für die Simulation der experimentell gewonnenen ESR-Spektren verwendet. Die Parameter der Spinsondenbindung im Albumin beschreiben die Simulation durch die Minimierung der Quadrate der Differenzen von simulierten und experimentell gewonnenen ESR-Spektren, wie sie beispielsweise in EP 0 973 043 A1 gezeigt sind.

Die Berechnung der Parameter erfolgt separat für die verschiedenen Typen der Bindungsstellen. Die Parameter, die die Bindungen der Spinsonde in den Bindungsstellen des Albuminmoleküls charakterisieren, werden durch ESR-Spektrensimulation berechnet. Ein Spin-Modell, das vorzugsweise auf der Hamilton-Funktion mit axialer Anisotropie basiert wird zur Berechnung jeder Komponente des Spektrums benutzt. Die Berechnung erfolgt wie in EP 0 973 043 A1, Seite 4 unten bis Seite 7 oben beschrieben.

Zur mathematischen Verarbeitung des ESR-Spektrums der Spinsonde wird das o.g. Computerprogramm angewandt, das den beschriebenen Berechnungsalgorithmus ausführt.

Die Zeit zur Verarbeitung eines ESR-Spektrums liegt unter 15 Sekunden.

Als Ergebnis der Simulationsrechnung eines jeden ESR-Spektrums erhält man einen Werteumfang von 48 Spinsondenparametern für die drei Albuminbindungsstellen. Jeder von diesen Parametern hat eine spezifische Varianz, korrespondierend zu den Zuständen der an den Albuminmolekülen gebundenen Spinsondenmolekülen, die den Konformationsstatus der Albuminmoleküle wiederspiegeln.-Insgesamt werden für den Fall, daß beispielsweise 16-Doxyl-Stearinsäure als Spinsonde dient, die 17 Parameter der Tabelle 2 aus dem Werteumfang selektiert, die den Albuminkonformationsstatus spezifisch charakterisieren.

Das Set aus 17 Parametern gemäß Tabelle 2 beschreibt den Zustand der in den Bindungsstellen des Albumins gebundenen Spinsondenmoleküle, die unter dem Einfluß der Bindungseigenschaften der Bindungsstellen den aktuellen Konformationszustand des Albuminmoleküls in Form biopysikalischer Parameter wiederspiegeln.

Aus dem ermittelten Set von 17 Parametern werden die Spinsondenverteilungs- und mobilitätsparameter für die einzelnen Aliquoten gemäß Tabelle 3 berechnet, wobei aus den Parametern der relativen Spinsondenkonzentration des Spinsondenpools $C_1$ bis $C_3$ die Verteilungscharakteristika der relativen Anzahl der in den Bindungsstellen gebundenen Spinsondenmoleküle $N_1$ bis $N_3$ durch Multiplikation von C1 bis C3 mit dem Verhältnis der Konzentrationen von Fettsäure (FS) zu Serumalbumin (SA) berechnet wird.

Die Mobilitätscharakteristika der in den Albuminbindungsstellen immobilisierten Spinsondenmoleküle werden gemäß der Formeln aus Tabelle 3 berechnet, wobei die Polaritätsfaktoren der Mikroumgebung der Bindungsstellen 1 und 2 aus den isotropischen Konstanten der HF-Struktur $A_1$ bzw. $A_2$ berechnet werden. Die Ausrichtungsfaktoren $S_1$ und $S_2$ werden aus den isotropischen Konstanten der HF-Struktur $A_1$ bzw. $A_2$ und der jeweiligen Anisotropie der HF-Struktur $\delta A_1$ bzw. $\delta A_2$ berechnet. Die Korrelationszeiten T'2 und T' '2 werden aus den Breiten der Spektrenlinien $W_L$, $W_M$ und $W_H$ berechnet.

Dabei werden die Bindungsparameter des Albumins vorzugsweise mittels der mathematischen Methode der Regression des Verhältnisses der Bindungsparameter der Spinsonden in den Aliquoten in Abhängigkeit von der Veränderung der Konzentrationen der Spinsonde und der Konzentrationen des polaren Reagenzes bestimmt. Als Bindungscharakteristika des Albumins wird ein Set der Bindungsparameter der Aliquoten bestehend aus

- $K_B$ = Bindungskonstante,
- $N_1^0$ = Kapazität der Fettsäurebindungsstelle 1 und
- $C_p$ = Kritische Konzentration des polaren Reagenzes

mittels Regression des Verhältnisses zwischen der relativen Anzahl der in den Fettsäurebindungsstellen gebundenen Spinsondenmoleküle ($N_1$, $N_2$, $N_3$) zur Konzentration des polaren Reagenzes (C) gemäß Formel I berechnet:

$$N_3 = \frac{1}{K_B} \cdot \frac{C_P \cdot N_1}{(C_P - C) \cdot (N_1^0 - N_1)} \quad \textbf{(I)}.$$

Als weitere Bindungsparameter des Albumins werden für die einzelnen Aliquoten die Parameter

- $R_2$ = Ratio der Kapazitäten der Fettsäurebindungsstellen 2 zu 1 im nativen Zustand des Albumins,
- $K_2$ = Flexibilitätsfaktor der Fettsäurebindungsstelle 2,
- $L_2$ = Limit der Konformationsstabilität des Albumins mittels Regression des Verhältnisses zwischen der relativen Anzahl der in den Fettsäurebindungsstellen gebundenen Spinsondenmoleküle ($N_1$, $N_2$, $N_3$) zur Konzentration des polaren Reagenzes (C) gemäß Formel II ermittelt:

$$N_2 = R_2 \cdot N_1 \cdot (1 + K_2 \cdot C \cdot (L_2 - N_1)) \quad \textbf{(II)}.$$

Die Formeln (I) und (II) beschreiben ein Model der Konformationsflexibilität des Systems der Fettsäurebindungsstellen des Albuminmoleküls, das erfindungsgemäß auf der Basis umfangreicher experimenteller Studien erarbeitet wurde.

Die Veränderungen der Transporteigenschaften des Albumins werden aus dem Set der berechneten Bindungsparameter des Albumins für die Aliquoten in Abhängigkeit von den für die Herstellung der Aliquoten angewandten Testbedingungen gemäß Tabelle 4 berechnet. Die vorzugsweise anzuwendenden Testbedingungen ermöglichen die Berechnung der Charakteristika, die die Beladung des Albumins mit Fettsäuren ($K_L$, $N_L^0$ - Testbedingung: C=0, Quotient Fettsäure / Albumin = 0,5), den Transport von Fettsäuren ($N_T^0$, $K_T$ - Testbedingung: C=0, Quotient Fettsäure / Albumin = 1,5) und die Entladung der Fettsäuren ($D_u$, $N_u^0$-Testbedingung: C=3,37 M, Quotient Fettsäure / Albumin = 1,5) bestimmen. Die Berechnung dieser Charakteristika erfolgt nach folgenden Formeln:

$$\text{Integrale Bindungskonstante} = K_L = K_B * (N_1^0 + N_2^0),$$

$$\text{Effektive Beladungskapazität} = N_L^0 = (N_1^0 + N_2^0),$$

$$\text{Effektive Transportkapazität} = N_T^0 = (N_1^0 + N_2^0),$$

$$\text{Integrale Transportbindungskonstante} = K_T = K_B * (N_1^0 + N_2^0),$$

$$\text{Dissoziationskonstante} = D_U = 1/K_B,$$

$$\text{Effektive Entladungskapazität} = N_U^0 = (N_1^0 + N_2^0).$$

Erfindungsgemäß kann das beschriebene ESR-Verfahren zur Diagnose und/oder Überwachung physiologischer oder pathologischer Veränderungen im menschlichen oder tierischen Körper angewandt werden, z.B. zur frühzeitigen Diagnose von Krebserkrankungen. Für die Diagnose von Krankheiten bzw. physiologischen Veränderungen gehen für die ESR-Screening-Analyse auf der Basis der Auswertung von mindestens 3 Aliquoten mit unterschiedlichen Konzentrationen der Spinsonde und des polaren Reagenzes jeweils bestimmte Bindungsparameter aus Tabelle 2 in eine Diskriminierungsfunktion ein, um die Cut-off-Werte für die jeweilige zu diagnostizierende Krankheit bzw. pathologische Veränderung zu bestimmen und mit den cut-off-Werten von Referenzproben zu vergleichen.

So werden beispielsweise zur Diagnose von Krebserkrankungen die Parameter $D_i$ gemäß Tabelle 5 ermittelt. Dabei ist bereits einer der Parameter $D_1$-$D_6$ ausreichend, um eine zuverlässige Diagnose zu treffen. Zur weiteren Erhöhung der Zuverlässigkeit der Aussagen kann es vorteilhaft sein, weitere Parameter, insbesondere $D_2$, $D_3$, $D_5$ oder $D_6$, oder alle sechs Parameter $D_i$ zu bestimmen. Ist einer der Parameter $D_i > 1$, so ist die Albuminkonformation gestört und es handelt sich beispielsweise um eine onkologische Erkrankung. Ist $D_i < 1$, so hat der Proband keine onkologische Erkrankung.

Die diagnostische Präzision der erfindungsgemäßen Diagnosemethode wurde an 212 Patienten mit Krebserkrankungen und an 87 Patienten ohne Krebserkrankungen überprüft (vgl. Tabelle 6).

Tabelle 6 belegt die hohe diagnostische Präzision des erfindungsgemäßen ESR-Verfahrens von über 90%. Es können auch Krebserkrankungen in einem sehr frühen Stadium der Erkrankung diagnostiziert werden. So wird mit der Berechnung von jeweils $D_2$, $D_3$, $D_5$ oder $D_6$ sogar eine höhere diagnostische Präzision von jeweils ca. 95% erzielt.

Die ESR-Analyse von Blutproben erlaubt somit die Diagnose von Krebs und anderen Erkrankungen oder physiologischen Veränderungen in sehr frühen Stadien der Erkrankung. Die Modifikation der Transportfunktion des Albumins basiert auf einer Blockierung der spezifischen Fettsäurebindungsstellen des Albumins, die bereits zu Beginn einer Erkrankung auftritt. Die Folge dieser Bindungsblockierung sind global gestörte Albuminfunktionen und -bindungseigenschaften für die normalen Transportaufgaben, nicht aber für die Versorgung von Neoplasmen und damit eine der Voraussetzungen für deren Wachstum. Die Blockierung an den Fettsäurebindungsstellen führt zu einer erheblichen Mangelversorgung normaler Zellen und auch zu Störungen des Immunsystems. Die mit gegenwärtigen Methoden der klinisch-chemischen Routinediagnostik bestimmbaren Parameter erfassen diese Veränderungen nicht; erste Reaktionen des Organismus auf die Tumorentwicklung sind nur mittels der erfindungsgemäßen ESR-Methode nachweisbar.

Das erfindungsgemäße Verfahren kann sowohl als In-prozess-Kontroll-Parameter bei der Produktion von albuminhaltigen Arzneimitteln als auch zur Bestimmung und Kontrolle der Qualität von albuminhaltigen Präparaten, vorzugsweise Blut- oder Plasmapräparaten, angewandt werden, indem die erfindungsgemäß bestimmten Veränderungen der Transporteigenschaften des Albumins ins Verhältnis gesetzt werden zu den Transporteigenschaften des Ausgangsmaterials und/oder des nativen Serumalbumins gesunder Probanden. Die Anwendung des erfindungsgemäßen Verfahrens schließt auch Anwendungen zur Bestimmung der Effektivität verschiedener Verfahren zur Reinigung des Albumins von an das Molekül gebundenen Liganden und die Verfahren wie z.B. Haemosorbtion und Haemodialyse zur Herauslösung von Endotoxinen, die jeweils Bindungscharakteristika und Transporteigenschaften des Albumins beeinflussen, durch den vergleich von Ausgangsmaterial und gereinigtem albuminhaltigen Material ein.

Die erfindungsgemäße Methode ist kosten- und zeiteffektiv. Sie erlaubt eine automatisierte Bestimmung von verschiedenen ESR-Spektren. Das Ergebnis jedes Screeningtests für 3 Aliquoten liegt innerhalb von weniger als 10 Minuten vor, für die komplexe ESR-Analyse von 8 - Aliquoten werden ca. 24 Minuten benötigt.

Gegenstand der Erfindung ist auch ein Testkit zur Durchführung des erfindungsgemäßen Verfahrens, der eine Mikrotiterplatte mit den fixierten, stabilisierten und exakt dosierten notwendigen unterschiedlichen Konzentrationen an Spinsonde und polarem Reagenz beinhaltet. Der Testkit kann auch lediglich die exakt dosierten Mengen an Spinsonde und polarem Reagenz in Extrakontainern, z.B. versiegelten Probenröhrchen, umfassen, so daß die vordosierten Mengen im Labor den aliquoten Teilen der zu untersuchenden Probe nur noch zugesetzt werden müssen.

Das zur Durchführung des erfindungsgemäßen Verfahrens verwendete ESR-Spektrometer wird als automatisierter ESR-Analysator den Anforderungen einfacher und zuverlässiger Handhabung in der modernen klinischen Laborpraxis gerecht, indem es automatische Gerätesteuerung, Signalregistrierung und Signalauswertung im Zusammenwirken mit einem Computerprogramm zur diagnostischen Analyse der Meßdaten integriert.

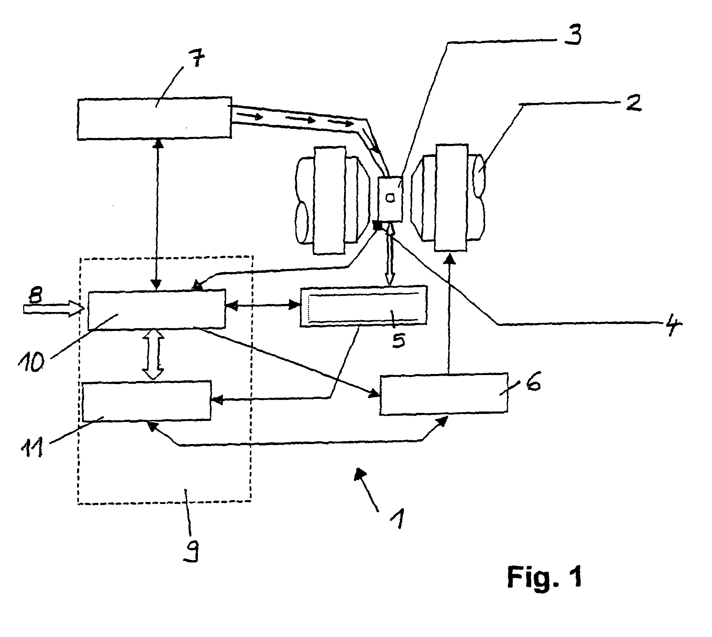

Das ESR-Spektrometer 1 zur Realisierung des Verfahrens nach der Erfindung besteht entsprechend der Darstellung in der Fig. 1 aus einem geschirmten Kompakt-Elektromagneten mit Hall-Stabilisierungssystem 2, einem Meßresonator 3, der mit einer homodynen UHF-Einheit 5 gekoppelt ist, einer Gerätesteuer- und einer Signalregistriereinheit 9 und einem System der Thermostatregelung 7 der Untersuchungsproben.

Die Gerätesteuer- und Signalregistriereinheit 9 besteht aus zwei Single-Chip-Computern (nicht dargestellt), von denen einer als System-Controller 10 für automatisiertes Tuning und Stabilisierung dient, während der zweite als ESR-Signalprozessor 11 den Scann-Algorithmus der Spektren generiert, die Signaldaten akkumuliert, digital filtert und aufzeichnet.

Für die Aufzeichnung der ESR-Spektren wird die Untersuchungsprobe in den Meßschacht des Resonators 3 eingesetzt, in dem die UHF-Wellen vom Haupt-Oszillator der UHF-Einheit 5 emittiert werden. Das ESR-Signal wird gemessen mittels einer homodynen Waveguide-Einheit als Quelle der UHF-Strahlung, die durch den Meßresonator 3 reflektiert wird.

Das Magnetfeld, das zur Anregung des ESR-Signals benötigt wird, wird durch den Elektromagneten 2 erzeugt. Die Spannungsquelle 6 des Elektromagneten 2 wird durch einen ESR-Signalprozessor 11 geregelt.

Die UHF-Einheit 5 wird geregelt durch die Gerätesteuereinheit 10, die die feine Frequenzabstimmung des Meß-resonators 3 mit dem Haupt-Oszillator der UHF-Einheit 5 gewährleistet, die Thermostatregelung 7 der Untersuchungsprobe kontrolliert und das ESR-Spektrometer 1 mit dem Personalcomputer 8 des Operators koppelt, der für die Spektrometersteuerung und die Datenanalyse genutzt wird.

Im Gegensatz zu bekannten ESR-Spektrometern, die nur ein Tuningelement entweder für die Generator- oder die Resonanzfrequenzabstimmung beinhalten, wobei die Abstimmung in einem großen Frequenzbereich nur mittels Tuning des Generators ermöglicht wird, während die Abstimmung des Resonators nur einen kleinen Frequenzbereich regelt, dafür aber eine stabile Frequenz bei der Messung verschiedener Proben gewährleistet, ist das Spektrometer mit zwei gekoppelten Steuerungsgeräten, eines für die Steuerung der Generatorfrequenz sowie ein zweites, für die Resonanzfrequenz ausgestattet. Das ist erforderlich, um einerseits eine große Bandbreite der Anwendung zur Untersuchung verschiedener und verschiedenartiger Proben zu ermöglichen und gleichzeitig die zwingend notwendige Kongruenz und Reproduzierbarkeit der Charakteristika der ESR-Spektren bei der Untersuchung aliquoter Proben gemäß dem erfinderischen Verfahren zu ermöglichen.

Eines der Steuerungsgeräte ist auf dem Haupt-Oszillator der UHF-Einheit 5 installiert zur Frequenzabstimmung im Bereich von 200-400, vorzugsweise 300 MHz der zentralen Frequenz von $9,45 \pm 0,5$ GHz. Das zweite Steuerungsgerät ist auf dem Meßresonator 3 installiert zur Abstimmung der Resonanzfrequenz im Bereich von 10-50, vorzugsweise 30 MHz mittels einer Resonatorhohlraumvolumenvariation mit Hilfe einer motorgetriebenen Zugstange.

Das Trimmen des Haupt-Oszillators der UHF-Einheit 5 nach dem Austausch der Untersuchungsproben erfolgt nur, wenn der Bereich der Resonanzfrequenzabstimmung unzureichend ist. Das geschieht im Falle eines Wechsels des Typs der Untersuchungsproben oder im Falle einer wesentlichen Änderung der Probenvorbereitungsprozedur.

Wenn also ein Set von Proben gleichen Typs untersucht wird, werden deren Spektren praktisch bei einer UHF-Frequenz aufgezeichnet. In diesem Fall ist die Basis-(Hintergrund-) Spektrallinie identisch für alle aufgezeichneten Spektren, was sehr wichtig für die Genauigkeit der anschließenden Berechnung der Charakteristika der untersuchten Objekte ist.

Das Thermostatregelungssystem 7 dient der Stabilisierung der Probentemperatur im Bereich von 30°C bis 45°C mit hoher Genauigkeit.

Im Gegensatz zu bekannten ESR-Spektrometern beinhaltet dieses System 7 ein zusätzliches Subsystem in Form einer zusätzlichen, nicht dargestellten Regelungsschleife. Die allgemeine Regelungsschleife des Thermostatregelungssystems 7 besteht aus einem wärmegeregelten Luftstrom, der je nach Erfordernis vorgeheizte oder vorgekühlte Luft in den Resonatorschacht bläst zur Temperaturregelung der Probenampulle.

Die zusätzliche Regelschleife des Thermostatregelsystems 7 dient der Präzisionserhöhung der Probentemperaturstabilisierung durch Minimierung der Gradienten innerhalb des Resonatorschachtes. Zu diesem Zweck wird der Resonatorkörper 3 mittels Selbstaufheizung des Magneten durch dessen Wärmestrahlung auf die konkrete Probentemperatur angewärmt. Die Temperatur des Resonatorkörpers 3 wird dazu mittels eines Temperatursensors 4 gemessen. Während der Unterbrechungen der Spektrenaufzeichnungen wird dazu die Spannungsquelle 6 des Elektromagneten 2 auf erhöhte oder reduzierte Werte geschaltet.

Die Struktur und die große Masse des geschirmten Kompakt-Elektromagneten 2 sichert zusätzlich die Thermoisolation des Resonators 3 von Umgebungseinflüssen.

Zur Analyse der ESR-Spektren mittels ESR-Spektrensimulation gemäß dem erfinderischen Verfahren war es im Gegensatz zu bekannten Spektrometern erforderlich, ein spezielles Verfahren der digitalen Filtration zur Gewährleistung der Aufzeichnung einer exakten Form der Spektren für die Berechnung der Spektrenparameter mittels Simulation zu entwickeln, da im Gegensatz zu bekannten Verfahren die Korrelation in dem gemessenen Signal die bei der Filtration von Signalrauschen und Impulsstörungen bzw. durch Rauschunterdrückung auftreten, minimisiert werden mußte, um die Anwendung des Spektrometers für das erfinderische Verfahren durch Gewährleistung der erforderlichen hohen Genauigkeit der ESR-Spektrenaufzeichnung, der Stabilität und der Sensivität des Spektrometers zu gewährleisten.

Dafür generiert der ESR-Signalprozessor einen Algorithmus des Spektrenscannings mittels Regelung der Spannungsquelle.

Die Ablesungen des ESR-Signals von der UHF-Einheit 5 werden mittels eines Analog/Digital-Konverters mit einer Frequenz von 10 KHz transformiert und im Speicher des Signalprozessors 11 akkumuliert.

Weil die typische Spektrenscannzeit mehr als eine Minute beträgt und die Anzahl der Spektrenpunkte weniger als 10.000 beträgt, wird jeder Spektrenpunkt aus 60 oder mehr Signalablesungen entwickelt.

Dessen ungeachtet ist ein bestimmter Teil der akkumulierten Spektrenablesungen gewöhnlich falsch, da das ESR-Spektrometer ein ultra-sensitives Instrument ist, das auf elektromagnetische Störungen oder mechanische Vibrationen reagieren kann.

Eine hohe Sensitivität und Stabilität des ESR-Spektrometers wird im Gegensatz zu bekannten ESR-Spektrometern dadurch erreicht, daß ein spezieller Algorithmus der Berechnung jeden Spektrenpunktes angewandt wird, bei dem *N* Aufzeichnungen des ESR-Signals $S_i$, akkumuliert für jeden Spektrenpunkt, summiert werden mit den speziellen Wichtungsfaktoren $k_i$. Diese Faktoren verhalten sich invers proportional zu den Quadraten der Messfehler der korrespondierenden Aufzeichnungen.

Der Fehler $\Delta_i$ der *i*-ten Signalablesung wird berechnet als die Differenz zwischen dieser Ablesung $S_i$ und dem arithmetischen Mittel der anderen (*N* - 1) Ablesungen:

$$\Delta_i = \frac{1}{N-1}\left(\sum_{p=1}^{N} S_p - S_i\right) - S_i$$

$$k_i = \frac{1}{(\Delta_i)^2} = (N-1)^2 / \left(\sum_{p=1}^{N} S_p - S_i \cdot N\right)^2$$

Der resultierende Ausdruck für die Berechnung des Signalpunktes lautet

$$S = \left(\sum_{i=1}^{N} k_i \cdot S_i\right) / \left(\sum_{i=1}^{N} k_i\right)$$

Wenn die Ablesung $S_i$ ein Impulsrauschen enthält, wird der Fehlerwert $\Delta_i$ erhöht (z.B. um das Zehnfache) und die korrespondierenden Wichtungsfaktoren $k_i$ werden um ein Vielfaches verringert (z.B. hundertfach). Dadurch werden im ESR-Spektrometer, im Gegensatz zu bekannten ESR-Spektrometern, Ablesungen mit Impulsrauschen von der Aufzeichnung der Spektreninformationen ausgeschlossen. Dieser Algorithmus wird für die Akkumulation eines jeden der gemessenen Punkte des Spektrums angewandt.

Im Ergebnis wird eine hohe Sensitivität und Stabilität des aufgezeichneten ESR-Spektrums gewährleistet. Gleichzeitig wird dadurch die Herstellung einer zusätzlichen Korrelation zwischen benachbarten Spektrenpunkten verhindert, die bei bekannten Verfahren der Filtration von ESR-Signalen eine der Hauptursachen der Verringerung der Genauigkeit der Bestimmung der Spektrenparameter mittels Spektrensimulation darstellt.

Die gewonnenen ESR-Spektren werden mit Hilfe einer speziellen ESR-Software (MMS) analysiert, wobei das Programm für die ESR-Screeninganalyse einen Meßalgorithmus zur Messung von 3 Aliquoten generiert, und die Ergebnisse gemäß der Vorschrift für die Auswertung anhand der Diskriminierungsfunktionen gemäß Tabelle 5 realisiert.

Für die Durchführung der komplexen ESR-Analyse generiert das Programm einen Meßalgorithmus für 5 bis vorzugsweise 8 Aliquoten, deren Ergebnisse anhand der Vorschrift zur Bestimmung der Transporteigenschaften des Albumins unter Anwendung der mathematischen Methode der Regression realisiert.

Das Programm gewährleistet eine einfache automatisierte Durchführung der Probenmessung und Auswertung ohne eine besondere Ausbildung oder Quailifikation des Meßpersonals zu erfordern.

Nachfolgend wird die Erfindung an Ausführungsbeispielen näher erläutert:

Beispiel 1

Untersuchung von Patienten mit onkologischen Erkrankungen und von gesunden Patienten mittels ESR-Screening-Analyse (3-Spektrenanalyse)

Blutserum wird durch Vollblutzentrifugation gewonnen und die Serumproben in drei Aliquote geteilt. Diese Serumproben von jeweils 50 μL werden mit 10, 12 und 14 μL einer alkoholischen Spinsondenlösung versetzt (Spinsondenendkonzentration 8,33*10⁻⁴ mol/L, 1,55*10⁻³ mol/L und 2,41*10⁻³ mol/L). Die präparierten Mischungen werden für 10 min bei 37°C unter kontinuierlichem Schütteln inkubiert.

Nach der Inkubation der präparierten Proben werden diese in drei Kapillaren überführt. Die ESR-Spektren werden für jede Kapillare im Resonator des ESR-Spektrometers bei einer konstanten Temperatur von $37 \pm 0,2$ °C aufgenommen.

Jedes aufgenommene ESR-Spektrum ist eine Superposition des spezifischen Spektrums der Spinsondenmoleküle, die an verschiedenen Bindungsstellen immobilisiert werden, was spezifisch für langkettige Fettsäuren ist. Diese Bindungsstellen sind im Serumalbumin des untersuchten Blutserums lokalisiert.

Die drei aufgenommenen ESR-Spektren werden in einen Computer eingeladen, um die Parameter der Spinsondenbindung zu berechnen. Diese Analyse wird separat für jede Bindungsstelle mit Hilfe der oben beschriebenen Methode der ESR-Spektren-Simulation durchgeführt.

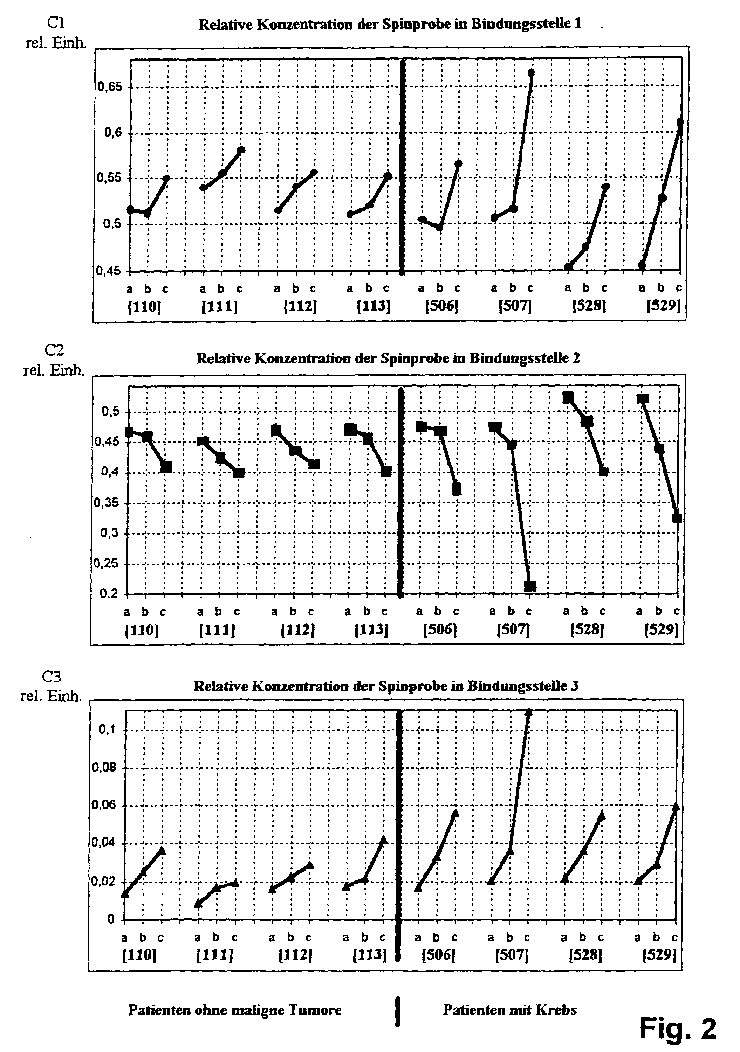

Tabelle 7 und Fig. 2 enthalten Beispiele für die Bestimmung der (16-DS)-Spinsondenparameter im Serumalbumin einiger Patienten mit und ohne Karzinomerkrankungen:

I. Patienten mit Krebserkrankung

1. Patient, study code 506.
Klinische Diagnose: Ösophagus-Karzinom.
2. Patient, study code 507.
Klinische Diagnose: Magen-Karzinom.
3. Patient, study code 528.
Klinische Diagnose: Mamma-Karzinom.
4. Patient, study code 529.

Klinische Diagnose: Lungen-Karzinom,.

II. Patienten ohne Krebserkrankung

1. Patient, study code 110, 42 Jahre.
Klinische Diagnose: Diffuse Mastopathie. Kein histologischer Nachweis für Krebs.
2. Patient, study code 111, 23 Jahre.
Klinische Diagnose: Gesunder Allgemeinzustand.
3. Patient, study code 112, 22 Jahre.
Klinische Diagnose: Gesunder Allgemeinzustand.
4. Patient, study code 113, 40 Jahre.
Klinische Diagnose: Rheumatische Herzerkrankung.

Tabelle 7 und Fig. 2 belegen, daß sich die gemessenen Bindungsparameter der Spinsonden für Krebspatienten und Patienten ohne Krebshinweise nur bei höheren Alkoholkonzentrationen des polaren Reagenzes unterscheiden (Serumproben B und C). Diese Unterschiede zeigen eine spezifische Modifikation der Konformationsmobilität der Serummoleküle in den Blutproben von Patienten mit Krebserkrankungen.

Beispiel 2

Komplexe ESR-Spektrenanalyse (3- und 8-Spektrenanalyse) der Albumintransportfunktion im Nativserum einer gesunden Population (Frauen und Männer)

Die Serumproben wurden mit einem Volumen von je 50 μL mit 3 resp. 8 verschiedenen Konzentrationen 16-Doxil-Stearinsäure-Spinsonde(gelöst in Ethylalkohol) gemischt, so daß Spinsondenendkonzentrationen von 0,83*10⁻³ mol/L bis und 2,34*10⁻³ mol/L und Ethylalkoholendkonzentrationen von 1,86 mol/L bis und 3,8 mol/L resultierten. Der pH-Werte der Serumproben betrug nach der Mischung mit den Spinsonden $7,4 \pm 0,05$. Die präparierten Mischungen wurden für 10 min bei 37 °C unter kontinuierlichem Schütteln inkubiert und nach der Inkubation in Glaskapillaren zur ESR-Spektrenaufnahme und -analyse überführt. Die Aufnahme der Spektren erfolgte im ESR-Spektrometer. Die ESR-Spektren wurden für jede Kapillare im Resonator des ESR-Spektrometers bei einer konstant gehaltenenen Temperatur von 37 ± 0,2 °C aufgenommen. Für alle aufgenommenen ESR-Spektren (3 und 8 Spektren) jeder Probe werden im integrierten ESR-Analyser die Parameter der Spinsondenbindung mit Hilfe einer Computersoftware berechnet. Für die Simulation der experimentell gewonnenen ESR-Spektren von verschiedenen Spinsonden wird ein ESR-Spektrummodell (Hamilton-Funktion mit axialer Anisotropie) verwendet. Die Parameter der Spinsondenbindung im Serumalbumin beschreiben die Simulation durch die Minimierung der Quadrate der Differenzen von simulierten und experimentell gewonnenen ESR-Spektren. Die Analyse wird separat für jede Bindungsstelle durchgeführt und durch das Computerprogramm die ESR-Parameter zur Charakteristik der Albuminfunktionalität und -konformation erstellt.

Die Parameter der Albumintransportfunktion im Nativserum gesunder Blut- und Plasmaspender stehen in Tabelle 8 als Beispiel für intakte Albumintransportfunktionen. Mit Hilfe der komplexen ESR-Spektrenanalyse konnten in den Serumproben dieser gesunden Spender keine Abnormalitäten festgestellt werden.

Beispiel 3:

Erweiterte ESR-Spektrenanalyse (3-Spektren- und 3-D-Analyse) der Albumintransportfunktion im Nativserum von Patienten mit hämatologischen Systemerkrankungen (Hämoblastosen, chronisch lymphatische Leukose (CML), Plasmocytom)

Blutserum wird durch Vollblutzentrifugation gewonnen und die Serumproben in drei Aliquote geteilt. Diese Serumproben von jeweils 50 μL werden mit 10, 12 und 14 μL einer alkoholischen Spinsondenlösung versetzt (Spinsondenendkonzentration $0,83*10^{-3}$ mol/L, $1,61*10^{-3}$ mol/L und $2,34*10^{-3}$ mol/L). Die präparierten Mischungen werden für 10 min bei 37°C unter kontinuierlichem Schütteln inkubiert.

Nach der Inkubation der präparierten Proben werden diese in drei Kapillaren überführt. Die ESR-Spektren werden für jede Kapillare im Resonator des ESR-Spektrometers bei einer konstanten Temperatur von 37 ± 0,2 °C aufgenommen. Die drei aufgenommenen ESR-Spektren werden in einen Computer eingeladen, um die Parameter der Spinsondenbindung zu berechnen. Diese Analyse wird separat für jede Bindungsstelle mit Hilfe der oben beschriebenen Methode der ESR-Spektren-Simulation mittels der Computersoftware durchgeführt.

Maligne hämatologische Systemerkrankungen können durch das ESR-Screening erfaßt werden. In Tabelle 9 sind die Diskriminierungsparameter der Serumproben von 5 Patienten mit CML und 3 Patienten mit Plasmocytom dargestellt. Die Diskriminierungsfunktionen D1-D5 ergeben ein typisches Bild für das Vorliegen einer Karzinomerkrankung, das auch in der 3-D-Analyse der Fettsäurebindungsstellen zum Ausdruck kommt.

Beispiel 4:

Erweiterte ESR-Spektrenanalyse (3-Spektren- und 3-D-Analyse) der Albumintransportfunktion von albuminhaltigen Arzneimittelproben zur Qualitätskontrolle

Die Proben der albuminhaltigen Arzneimittel (Albuminlösungen, gefrorenes Frischplasma) wurden mit einem Volumen von je 50 μL wurden mit 3 resp. 8 verschiedenen Konzentrationen 16-Doxil-Stearinsäure-Spinsonde (gelöst in Ethylalkohol) gemischt, so daß Spinsondenendkonzentrationen von $0,83*10^{-3}$ mol/L bis und $2,34*10^{-3}$ mol/L und Ethylalkoholendkonzentrationen von 1,86 mol/L bis 3,8 mol/L resultierten. Der pH-Wert der Serumproben betrug nach der Mischung mit den Spinsonden 7,4 + 0,05. Die präparierten Mischungen wurden für 10 min bei 37 °C unter kontinuierlichem Schütteln inkubiert und nach der Inkubation in Glaskapillaren zur ESR-Spektrenaufnahme und -analyse überführt. Die Aufnahme der Spektren erfolgte im ESR-Spektrometer. Die ESR-Spektren wurden für jede Kapillare im Resonator des ESR-Spektrometers bei einer konstant gehaltenen Temperatur von 37 + 0,2 °C aufgenommen. Für alle aufgenommenen ESR-Spektren (3 und 8 Spektren) jeder Aliquoten werden im integrierten ESR-Analyser die Parameter der Spinsondenbindung mit Hilfe der Computersoftware berechnet. Für die Simulation der experimentell gewonnenen ESR-Spektren von verschiedenen Spinsonden wird ein ESR-Spektrummodell (Hamilton-Funktion mit axialer Anisotropie) verwendet. Die Parameter der Spinsondenbindung im Serumalbumin beschreiben die Simulation durch die Minimierung der Quadrate der Differenzen von simulierten und experimentell gewonnenen ESR-Spektren. Die Analyse wird separat für jede Bindungsstelle durchgeführt und durch das Computerprogramm die ESR-Parameter zur Charakteristik der Albuminfunktionalität und -konformation erstellt.

Bei der Herstellung von albuminhaltigen Arzneimitteln ist die erweiterte ESR-Spektrenanalyse (3-Spektren- und 3-D-Analyse) der Albumintransportfunktion zur Qualitäts- und Inprozess-Kontrolle geeignet. Die Tabellen 10 und 11 zeigen die prozessbegleitende Anwendung der ESR-Technologie in der 3- und 8-Spektrenanalyse für unterschiedlich gewonnene (Vollblutplasma vs. Aphereseplasma) und behandelte (gefilterte = leukozytendepletierte) Plasmaprodukte (Tabelle 10), sowie für intaktes und denaturiertes Albumin (Tabelle 11). Es wird deutlich, daß die Kapazität der Albumintransportfunktion des Endprodukte (z.B. Albuminlösungen, gefrorenes Frischplasma zur Transfusion) bewertet werden kann, aber auch einzelne Abschnitte des Herstellungsprozesses hisichtlich ihres Einflusses auf die qualitativen Albumintransporteigenschaften analysiert werden können.

Tab. 1

| **Bevorzugte Konzentrationen der Spinsonde (16 Doxilstearinsäure) und des polaren Reagenzes (Ethylalkohol)** | | | |
|---|---|---|---|
| 1. ESR-Screening-Analyse | | | |
| **Bezeichnung der Aliquote** | **Endkonzentrationen CSpinsonde / CAlbumin** | **Endkonzentrationen der Spinsonde, $10^{-3}$M für Serumalbumin*,** | **Endkonzentrationen der polaren Reagenz,** |
| **A** | 1,6500 | 0,83 | 2,90 |
| **B** | 3,2870 | 1,61 | 3,37 |
| **C** | 4,9430 | 2,34 | 3,80 |
| 2. Komplexe ESR-Spektrenanalyse | | | |
| **Bezeichnung der Aliquote** | **Endkonzentrationen CSpinsonde / CAlbumin** | **Endkonzentrationen der Spinsonde, $10^{-3}$M für Serumalbumin*,** | **Endkonzentrationen der polaren Reagenz, M**** |
| **A** | 1,6500 | 0,83 | 2,90 |
| **B** | 3,2870 | 1,61 | 3,37 |
| **C** | 4,9430 | 2,34 | 3,80 |
| **D** | 2,3100 | 1,09 | 3,80 |
| **E** | 3,8346 | 1,82 | 3,80 |
| **F** | 3,2868 | 0,89 | 1,86 |
| **G** | 4,9434 | 1,31 | 2,14 |
| **H** | 5,0440 | 1,78 | 2.90 |
| Zur Darstellung der Grafiken wird ein Punkt (P0) mit den Endkonzentrationen | | | |
| **P0** | 1,6500 | 0,45 | 1,58 |

durch das Programm gesetzt.
P0 = experimentaler Grenzwert der nativen Konformation des Albumins
*= CAlbumin für Serum oder Plasma physiologisch 35 - 45 g/l

**= Werte für polares Reagenz Ethylalkohol

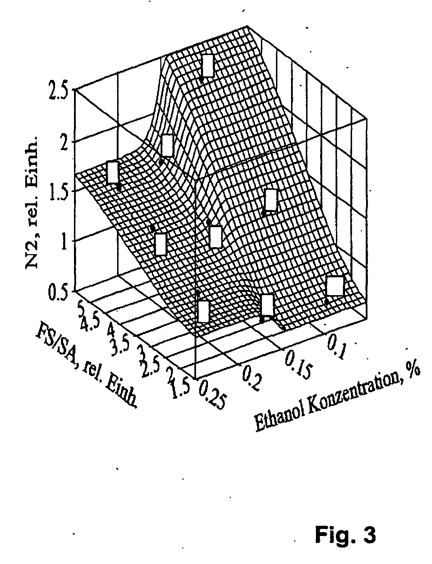

Die Matrix der Konzentrationsverteilung der Aliquoten (Beispiel - rel. Anzahl Spinsondenmoleküle in BS-2) ist in Fig. 3 dargestellt.

**EP 1 269 213 B1**

**Tab. 2:** 16-DS-Spinsondenparameter, die von ESR-Spektren ermittelt wurden und ihre Korrelation mit einer Charakteristik der Albuminkonformation und -funktionalität.

| Parameter der Spinsondenbindung | Einheit | Bez. | $X_i$ | Biophysikalische Charakteristika |
|---|---|---|---|---|
| **Erste Komponente des Spektrums** | | | | **Bindungsstelle 1** |
| 1. Relative Spinsondenkonzentration | relative Einheit | $C_1$ | 0,6 | Spezifische Kapazität der Bindungsstelle |
| 2. Isotropischer g-Faktor | relative Einheit | $g_{o1}$ | 2,0 | Integrale Charakteristik der Bindungs-stellen-Konformation |
| 3. Grad der g-Faktor Anisotropie | relative Einheit | $\delta g_1$ | -6, 10E$^{-04}$ | Charakteristik der Mikroumgebung der Spinsonde in der Bindungsstelle |
| 4. Isotropische HFS-Konstante | mT | $A_1$ | 1,62 | Charakteristik d. Größe d. Bindungsstelle (in inverser Proportion) |
| 5. Grad der HFS Anisotropie | relative Einheit | $\delta A_1$ | 1,27 | Grad der Spinsonden-Ausrichtung |
| 6. Breite der low-field Spektrallinie | mT | $W_{L1}$ | 0,28 | Charakteristik der Spinsondenmobilität |
| 7. Breite der zentralen Spektrallinie | mT | $W_{M1}$ | 0,27 | Charakteristik der Spinsondenmobilität |
| 8. Breite der high-field Spektrallinie | mT | $W_{H1}$ | 0,31 | Charakteristik der Spinsondenmobilität |
| **Zweite Komponente des Spektrums** | | | | **Bindungsstelle 2** |
| 9. Relative Spinsondenkonzentration | relative Einheit | $C_2$ | 0,39 | Spezifische Kapazität der Bindungsstelle |
| 10 Isotropischer g-Faktor | relative Einheit | $g_{o2}$ | 2,0 | Integrale Charakteristik der Bindungs-stellen-Konformation |
| 11. Grad der g-Faktor Anisotropie | relative Einheit | $\delta g_2$ | 8,30E$^{-05}$ | Charakteristik der Mikroumgebung der Spinsonde in der Bindungsstelle |
| 12. Isotropische HFS-Konstante | mT | $A_2$ | 1,47 | Charakteristik d. Größe d. Bindungsstelle (in inverser Proportion) |
| 13. Grad der HFS Anisotropie | relative Einheit | $\delta A_2$ | -0,12 | Grad der Spinsonden-Ausrichtung |
| 14. Breite der low-field Spektrallinie | mT | $W_{L2}$ | 0,44 | Charakteristik der Spinsondenmobilität |
| 15. Breite der zentralen Spektrallinie | mT | $W_{M2}$ | 0,32 | Charakteristik der Spinsondenmobilität |
| 16. Breite der high-field Spektrallinie | mT | $W_{H2}$ | 0,74 | Charakteristik der Spinsondenmobilität |
| **Dritte Komponente des Spektrums*** | | | | **Bindungsstelle 3** |
| 17. Relative Spinsondenkonzentration | relative Einheit | $C_3$ | 9,71E$^{-03}$ | Spezifische Kapazität der Bindungsstelle |

\* Bemerkung: Weil die dritte Komponente des Spektrums mit den Spinsonden in Bindungsstellen niedriger Affinität korrespondiert, sind ihre anderen Charakteristika unbedeutend.

**Tabelle 3**

<div style="border:1px solid">

### Kalkulation der Spinsondenverteilungs- und -mobilitätsparameter

| *ESR-Spektren Parameter* | *Verteilungscharakteristika* |
|---|---|
| Relative Konzentrationen des Spinsondenpools<br>Spektrum-komponenten | relative Anzahl der in den Bindungsstellen gebundenen Spinsondenmoleküle<br>Bindungs-stelle |

*1*    $C_1$ $\longrightarrow$   *1*   $N_1 = FS/SA\ C_1$

*2*    $C_2$ $\longrightarrow$   *2*   $N_2 = FS/SA\ C_2$

*3*    $C_3$ $\longrightarrow$   *3*   $N_3 = FS/SA\ C_3$

*Mobilitätscharakteristika*

isotropische Konstanten der HF-Struktur     Polaritätsfaktoren der Mikroumgebung

*1*    $A_1$ $\longrightarrow$   *1*

$$P_1 = \frac{A^\circ_{XX} + A^\circ_{YY} + A^\circ_{ZZ}}{3 \cdot A_1}$$

*2*    $A_2$ $\longrightarrow$   *2*

$$P_2 = \frac{A^\circ_{XX} + A^\circ_{YY} + A^\circ_{ZZ}}{3 \cdot A_2}$$

Anisotropie der HF-Struktur     Ausrichtungsfaktoren

*1*    $\Gamma_{A_1}$ $\longrightarrow$   *1*

$$S_1 = \frac{\delta A_1 \cdot A_1 + 1{,}5 \cdot \left(\frac{1{,}1 \cdot 10^{-7}}{\tau}\right)^{2/3}}{A^\circ_{ZZ} - \frac{1}{2} \cdot \left(A^\circ_{XX} + A^\circ_{YY}\right)} \cdot \frac{1}{P_1}$$

*2*    $\Gamma_{A_2}$ $\longrightarrow$   *2*

$$S_2 = \frac{\delta A_2 \cdot A_2 + 1{,}5 \cdot \left(\frac{1{,}1 \cdot 10^{-7}}{\tau}\right)^{2/3}}{A^\circ_{ZZ} - \frac{1}{2} \cdot \left(A^\circ_{XX} + A^\circ_{YY}\right)} \cdot \frac{1}{P_2}$$

Breite der Spektrenlinien     Korrelationszeit

*2*    $W_L$

*2*    $W_M$

$$T_2' = 6{,}5 \cdot 10^{-10} \cdot W_M \cdot \left(\frac{W_H}{W_M} + \frac{W_L}{W_M} - 2\right)$$

*2*    $W_H$

$$T_2'' = 6{,}65 \cdot 10^{-10} \cdot W_M \cdot \left(\frac{W_H}{W_L} - 1\right)$$

---

$A^\circ_{XX} = 0{,}59\ mT$

$A^\circ_{YY} = 0{,}54\ mT$     bekannte Konstanten für Nitroxid- FS Spinsonden

$A^\circ_{ZZ} = 3{,}29\ mT$

$\tau = 35 \times 10^{-6}\ s$

</div>

**Tabelle 4**

## Bestimmung der Parameter der Transporteigenschaften des Albumins

**Charakteristika der FS-Bindungsstellen Flexibilität**

*Funktionale Abhängigkeit der Bindungsparameter*

• *Bindungskonstante*

$$Kb = B \cdot (Cp - Calc) \cdot 10^7$$

• *Effektive Kapazität der BS-1*  $\quad N_1^0$

• *Effektive Kapazität der BS-2*

$$N_2^0 = R_2 \cdot (1 - K_2 \cdot Calc \cdot (L_2 - N_1)) \cdot N_1^0$$

---

**Charakteristika - Beladung mit Fettsäuren**

| *Testbedingungen:* | $Calc = 0$ |
| *(physiologisch normal)* | $FS/SA = 0,5$ |

• *Integrale Bindungskonstante*  $\quad K_L = Kb \cdot (N_1^0 + N_2^0)$

Bestimmt die Effektivität einer Moleküladsorption durch das Albumin

• *Effektive Kapazität*  $\quad N_L^0 = (N_1^0 + N_2^0)$

Bestimmt die effektive Kapazität für die Beladung

---

**Charakteristika - Transport von Fettsäuren**

| *Testbedingungen:* | $Calc = 0$ |
| *(physiologisch normal)* | $FS/SA = 1,5$ |

• *Effektive Kapazität*  $\quad N_T^0 = (N_1^0 + N_2^0)$

Bestimmt die effektive Kapazität für den Transport im vaskularen System

• *Integrale Bindungskonstante*  $\quad K_T = Kb \cdot (N_1^0 + N_2^0)$

Bestimmt die Fixierung während des Transports im vaskularen System

---

**Charakteristika - Entladung von Fettsäuren**

| *Testbedingungen:* | $Calc = 3,37\,M$ |
| *(Stimulierung der Konformationsänderung des Albumins)* | $FS/SA = 1,5$ |

• *Dissoziations Konstante*  $\quad D_U = 1/Kb$

Bestimmt die Effektivität der Dissoziation

• *Effektive Kapazität*  $\quad N_U^0 = (N_1^0 + N_2^0)$

Bestimmt Kapazität des SA für die Absorbtion von Metaboliten

EP 1 269 213 B1

Tab. 5:

| Beispiele der Diskriminierungsfunktionen | |
|---|---|
| **Definition* $D_i$** | **Beschreibung der Parameter** |
| $D_1 = K_1 \times (\|y_2\text{-}y_1\| + \|y_3\text{-}y_2\|)$, wobei $y_1$=C1(**A**), $y_2$=C1(**B**), $y_3$=C1(**C**) | Drei Parameter der relativen Spinsondenkonzentration in der Bindungsstelle 1 des Serumalbumins von drei Serumproben **A**, **B** und **C** |
| $D_2 = K_2 \times (y_3\text{-}y_1\text{-}0{,}5)$, wobei $y_1$=C2(**A**), $y_3$=C2(**C**) | Zwei Parameter der relativen Spinsondenkonzentration in der Bindungsstelle 2 des Serumalbumins von den Serumproben **A** und **C** |
| $D_3 = K_3 \times (\|y_2\text{-}y_1\| + \|y_3\text{-}y_2\|)$, wobei $y_1$=C2(**A**), $y_2$=C2(**B**), $y_3$=C2(**C**) | Drei Parameter der relativen Spinsondenkonzentration in der Bindungsstelle 2 des Serumalbumins von drei Serumproben **A**, **B** und **C** |
| $D_4 = K_4 \times (\,C3(\textbf{C}) - C3(\textbf{A})+0{,}5)$ | Zwei Parameter der relativen Spinsondenkonzentration in der Bindungsstelle 3 des Serumalbumins von den Serumproben **A** und **C** |
| $D_5 = K_5 \times (\|C1(C)\text{-}C1(A)\| + \|C2(C)\text{-}C2(A)\| + \|C3(C)\text{-}C3(A)\|)$ | Sechs Parameter der relativen Spinsondenkonzentration in verschiedenen Bindungsstellen des Serumalbumins von den Serumproben **A** und **C** |
| $D_6 = 2\text{-}P_2\,(C) * K_6$ | Polaritätsfaktor der Spinsondenumgebung in der Fettsäurebindungsstelle 2 der Serumprobe **C** |

* Die Parameter C1, C2 und C3 sind die Werte der relativen Spinsondenkonzentration jeweils in den Bindungsstellen 1, 2 und 3. Der Polaritätsfaktor $P_2$ wird berechnet $P_2$=1,47333 / $A_2$ (mT), wobei A2 die isotropische HFS-Konstante der Fettsäurebindungsstelle 2 darstellt. Die Symbole **A**, **B** und **C** kennzeichnen die Probennummern jeweils einer Serie der gemessenen Serumproben einer untersuchten Blutprobe wie folgt:

**A** - Serumprobe mit einer Spinsondenendkonzentration von $8{,}3*10^{-4}$mol/l
B - Serumprobe mit einer Spinsondenendkonzentration von 1,61*10-3mol/l
C - Serumprobe mit einer Spinsondenendkonzentration von 2,34*10-3mol/l.

Die Koeffizienten $K_1$ bis $K_6$ sind abhängig von den konkreten Konzentrationen der verwandten Reaktive und vom Ergebnis der Erweiterung und Präzisierung der Daten zu den Parametern des Serumalbumins einer möglichst großen Zahl von Krebspatienten und Gesunden.
Die Koeffizienten $K_1$ bis $K_6$ können z.B. die Werte $K_1$=7,843    $K_2$= -1,517    $K_3$=6,3    $K_4$=1,881    $K_5$=3,009    $K_6$=1,002 annehmen.

Tab. 6:

| Diagnostische Präzision von Tests auf der Basis von Diskriminierungsfunktionen im Ergebnis einer klinischen Studie von 212 Patienten mit Krebserkrankungen (Magen-, Ösophagus-, Rektum-, Leber-, Lungen-, Brust-, Prostata-Karzinom) und 87 Patienten ohne Krebserkrankung. | | | |
|---|---|---|---|
| **Diskriminierungsfunktionen** | **Sensitivität d. Diagnostik, %** | **Spezifität d. Diagnostik, %** | **Präzision d. Diagnostik, %** |
| $D_1$ | 92,3±7,4 | 92,3±7,4 | 92,3±7,4 |
| $D_2$ | 96,0±4,0 | 92,3±7,4 | 95,0±5,0 |
| $D_3$ | 96,0±4,0 | 96,0±4,0 | 96,0±4,0 |
| $D_4$ | 96,0±4,0 | 84,6±10,0 | 90,3±7,1 |
| $D_5$ | 96,0±4,0 | 92,3±7,4 | 94,2±5,2 |

Tab. 7:

| Studien-code | Bindungsparameter* der Spinsonde in den 3 Albumin-Bindungsstellen | | | | | | | | |
|---|---|---|---|---|---|---|---|---|---|
| | Serumprobe **A** | | | Serumprobe **B** | | | Serumprobe **C** | | |
| | $C1$ | $C2$ | $C3$ | $C1$ | $C2$ | $C3$ | $C1$ | $C2$ | $C3$ |
| *Patienten mit Krebs* | | | | | | | | | |
| **506** | 0,504 | 0,476 | 0,0171 | 0,495 | 0,468 | 0,0328 | 0,504 | 0,373 | 0,0561 |
| **507** | 0,506 | 0,474 | 0,0202 | 0,516 | 0,444 | 0,0359 | 0,665 | 0,212 | 0,1092 |
| **528** | 0,453 | 0,524 | 0,0218 | 0,475 | 0,485 | 0,0357 | 0,539 | 0,401 | 0,0545 |
| **529** | 0,457 | 0,521 | 0,0203 | 0,528 | 0,438 | 0,0295 | 0,609 | 0,324 | 0,0596 |
| *Patienten ohne maligne Tumore* | | | | | | | | | |
| **110** | 0,517 | 0,469 | 0,0135 | 0,512 | 0,461 | 0,0251 | 0,549 | 0,409 | 0,0369 |
| **111** | 0,539 | 0,451 | 0,0083 | 0,555 | 0,425 | 0,0168 | 0,579 | 0,398 | 0,0193 |
| **112** | 0,514 | 0,469 | 0,0161 | 0.541 | 0,435 | 0,0222 | 0,556 | 0,412 | 0,0287 |
| **113** | 0,510 | 0,471 | 0,0175 | 0,519 | 0,456 | 0,0215 | 0,551 | 0,401 | 0,0421 |

Bindungsparameter von Spinsonden in den spezifischen Bindungsstellen des Albumins der in den Ausführungsbeispielen und Tab.3 angeführten Patienten mit und ohne Krebserkrankung.

*Für jeden der untersuchten Patienten wurden die dargestellten Parameter durch eine ESR-Analyse von drei Serumproben, bezeichnet mit A, B, C bestimmt. Die Proben **A**, **B** und **C** wurden jeweils mit 10 µl, 12 µl und 14 µl alkoholischer Lösung der Spinsonde gemischt (Spinsondenendkonzentration $8,33*10^{-4}$ mol/l, $1,55*10^{-3}$ mol/l bzw. $2,41*10^{-3}$ mol/l).

Die dargestellten Parameter bezeichnen:

**C 1** - Relative Spinsondenkonzentration in der Bindungsstelle 1;

**C 2** - Relative Spinsondenkonzentration in der Bindungsstelle 2;

**C 3** - Relative Spinsondenkonzentration in der Bindungsstelle 3

Tabelle 8:

| ESR-Parameter gesunder Personen (16 männlich, 18 weiblich). | | | | |
|---|---|---|---|---|
| **Screeningparameter der Albuminfunktionalität** | | | | |
| Parameter | Einheit | Anzahl | Mittelwert | SD |
| **D1** | rel. Einh. | **32** | **0,617** | **0,076** |
| **D2** | rel. Einh. | **32** | **0,892** | **0,023** |
| **D3** | rel. Einh. | **32** | **0,663** | **0,089** |
| **D4** | rel. Einh. | **32** | **0,956** | **0,002** |
| **D5** | rel. Einh. | **32** | **0,487** | **0,073** |
| **Physiko-chemische Charakteristika der Fettsäurebindungsstellen** | | | | |
| Parameter | Einheit | Anzahl | Mittelwert | SD |
| $\mathbf{K_B}$ | $10^7$M | **32** | **8,44** | **0,46** |
| $\mathbf{N_1^0}$ | rel. Einh. | **32** | **10,32** | **0,11** |
| $\mathbf{R_2}$ | rel. Einh. | **32** | **0,87** | **0,02** |
| $\mathbf{C_p}$ | rel. Einh. | **32** | **0,30** | **0,00** |
| $\mathbf{K_2}$ | rel. Einh. | **32** | **1,49** | **0,11** |
| $\mathbf{L_2}$ | rel. Einh. | **32** | **2,43** | **0,12** |

Tabelle 8: (fortgesetzt)

| ESR-Parameter gesunder Personen (16 männlich, 18 weiblich). | | | | |
|---|---|---|---|---|
| **Faktoren von Albumin-Transport, -Ladung und -Entladung** | | | | |
| Parameter | Einheit | Anzahl | Mittelwert | SD |
| $N_1^0$ | rel. Einh. | **32** | **10,32** | **0,11** |
| $N_T^0$ | rel. Einh. | **32** | **19,32** | **0,36** |
| $N_L^0$ | rel. Einh. | **32** | **19,32** | **0,36** |
| $N_u^0$ | rel. Einh. | **32** | **22,24** | **0,27** |
| $K_T$ | $10^7 M$ | **32** | **150,44** | **6,95** |
| $K_L$ | $10^7 M$ | **32** | **150,44** | **6,95** |
| **Du** | $10^{-7} M^{-1}$ | **32** | **0,06** | **0,00** |

Tabelle 9

| Screeningparameter der Albuminfunktionalität | | | | | | | |
|---|---|---|---|---|---|---|---|
| | | **CLL** | | | **Plasmocytom** | | |
| Parameter | Einheit | Anzahl | Mittelwert | SD | Anzahl | Mittelwert | SD |
| **D1** | rel. Einh. | **5** | **1,134** | **0,218** | **3** | **1,424** | **0,414** |
| **D2** | rel. Einh. | **5** | **1,030** | **0,033** | **3** | **1,096** | **0,085** |
| **D3** | rel. Einh. | **5** | **1,127** | **0,138** | **3** | **1,402** | **0,352** |
| **D4** | rel. Einh. | **5** | **0,980** | **0,025** | **3** | **1,006** | **0,007** |
| **D5** | rel. Einh. | **5** | **1,219** | **0,165** | **3** | **1,320** | **0,337** |

Tabelle 10

| ESR-Parameter von unterschiedlich gewonnenen und behandelten Plasmaprodukten (gefrorenes Frischplasma). | | | | | | | | | | |
|---|---|---|---|---|---|---|---|---|---|---|
| | | Vollblutplasma | | | Aphereseplasma | | | gefiltertes Plasma | | |
| Parameter | Einheit | Anzahl | Mittelwert | SD | Anzahl | Mittelwert | SD | Anzahl | Mittelwert | SD |
| *Screeningparameter der Albuminfunktionalität* | | | | | | | | | | |
| D1 | rel. Einh. | 21 | **1,40** | *0,24* | 10 | **2,58** | *0.65* | 21 | **1,72** | *0,35* |
| D2 | rel. Einh. | 21 | **1,10** | *0,05* | 10 | **1,22** | *0,09* | 21 | **1,10** | *0.05* |
| D3 | rel. Einh. | 21 | **1,51** | *0,20* | 10 | **1,91** | *0,36* | 21 | **1,76** | *0,30* |
| D4 | rel. Einh. | 21 | **0,96** | *0,01* | 10 | **0,96** | *0,01* | 21 | **0,97** | *0,01* |
| D5 | rel.Einh. | 21 | **1,21** | *0,19* | 10 | **1,73** | *0.30* | 21 | **1,22** | *0,17* |
| *Physiko-chemische Charakteristika der Fettsäurebindungsstellen* | | | | | | | | | | |
| $K_B$ | $10^7\ M^{-1}$ | 21 | **7,62** | *1,02* | 10 | **16,73** | *2,80* | 21 | **9,18** | *1,63* |
| $N_1^0$ | rel. Einh. | 21 | **9,09** | *0.47* | 10 | **6,99** | *0,59* | 21 | **8,93** | *0,52* |
| $R_2$ | rel. Einh. | 21 | **0,90** | *0,05* | 10 | **1,12** | *0,10* | 21 | **0,80** | *0,07* |
| $C_p$ | rel. Einh. | 21 | **0,34** | *0,01* | 10 | **0,32** | *0,02* | 21 | **0,35** | *0,02* |
| $K_2$ | rel. Einh. | 21 | **1,72** | *0,12* | 10 | **1,38** | *0,17* | 21 | **2,11** | *0,17* |
| $L_2$ | rel. Einh. | 21 | **1,97** | *0,16* | 10 | **0,72** | *0,47* | 21 | **2,29** | *0.18* |
| *Faktoren von Albumin-Transport. -Ladung und -Entladung* | | | | | | | | | | |
| $N_1^0$ | rel. Einh. | 21 | **9,09** | *0,47* | 10 | **6,99** | *0,59* | 21 | **8,93** | *0,52* |
| $N_T^0$ | rel. Einh. | 21 | **17,3** | *1,04* | 10 | **15,0** | *1,58* | 21 | **16,1** | *1,19* |
| $N_L^0$ | rel. Einh. | 21 | **17,3** | *1,04* | 10 | **15,0** | *1,58* | 21 | **16,1** | *1,19* |
| $N_U^0$ | rel. Einh. | 21 | **18,8** | *1,05* | 10 | **13,6** | *1,11* | 21 | **18,4** | *1,23* |
| $K_T$ | rel. Einh. | 21 | **117,9** | *9,7* | 10 | **216,3** | *20,9* | 21 | **125,6** | *15.0* |
| $K_L$ | rel. Einh. | 21 | **117,9** | *9,7* | 10 | **216,3** | *20,9* | 21 | **125,6** | *15,0* |
| $D_U$ | rel. Einh. | 21 | **0,059** | *0,006* | 10 | **0,041** | *0,005* | 21 | **0,052** | *0,005* |

Tabelle 11: ESR-Parameter von intakten und denaturierten Albuminlösungen.

## Screeningparameter der Albuminfunktionalität

| intaktes Albumin | | | | | denaturiertes Albumin | |
|---|---|---|---|---|---|---|
| Parameter | Einheit | Anzahl | Mittelwert | SD | Anzahl | Mittelwert |
| D1 | rel. Einh. | 5 | 0,239 | 0,193 | 1 | 0,574 |
| D2 | rel. Einh. | 5 | 0,784 | 0,058 | 1 | 0,919 |
| D3 | rel. Einh. | 5 | 0,105 | 0,224 | 1 | 0,668 |
| D4 | rel. Einh. | 5 | 0,989 | 0,006 | 1 | 0,997 |
| D5 | rel. Einh. | 5 | 0,170 | 0,185 | 1 | 0,630 |
| *Physiko-chemische Charakteristika der Fettsäurebindungsstellen* | | | | | | |
| $K_B$ | $10^7\ M^{-1}$ | $K_B$ | 26,5 | 6,3 | 1 | 3,2 |
| $N_1^0$ | rel. Einh. | $N_1^0$ | 6,30 | 0,86 | 1 | 11,00 |
| $R_2$ | rel. Einh. | $R_2$ | 0,74 | 0,05 | 1 | 0,53 |
| $C_P$ | rel. Einh. | $C_P$ | 0,29 | 0,02 | 1 | 0,37 |
| $K_2$ | rel. Einh. | $K_2$ | 0,46 | 0,26 | 1 | 1,32 |
| $L_2$ | rel. Einh. | $L_2$ | -3,19 | 2,73 | 1 | 3,06 |
| *Faktoren von Albumin-Transport, -Ladung und -Entladung* | | | | | | |
| $N_1^0$ | rel. Einh. | $N_1^0$ | 6,30 | 0,86 | 1 | 11,00 |
| $N_T^0$ | rel. Einh. | $N_T^0$ | 10,9 | 1,57 | 1 | 16,8 |
| $N_L^0$ | rel. Einh. | $N_L^0$ | 10,9 | 1,57 | 1 | 16,8 |
| $N_U^0$ | rel. Einh. | $N_U^0$ | 10,9 | 1,59 | 1 | 19,4 |
| $K_T$ | rel. Einh. | $K_T$ | 281 | 69 | 1 | 53 |
| $K_L$ | rel. Einh. | $K_L$ | 281 | 69 | 1 | 53 |
| $D_U$ | rel. Einh. | $D_U$ | 0,04 | 0,01 | 1 | 0,07 |

In Fig. 1 bedeuten:

1 ESR-Spektrometer

2 Elektromagnet

3 Meßresonator

4 Temperatursensor

5 UHF-Einheit

6 Spannungsquelle

7 Thermostatregelungssystem

8 Personalcomputer

9 Gerätesteuer- und Signalregistriereinheit

10 Gerätesteuereinheit

11 Signalprozessor

**Fig. 2** zeigt die induzierte Modifikation der Bindungsparameter von Spinproben in Serumalbumin von Patienten mit und ohne Krebserkrankung als ein Ergebnis des Alkoholeinflusses auf die Albuminmolekülkonformation. Die dargestellten Kurven zeigen die Abhängigkeit der Spinprobenparameter von der Alkoholkonzentration in der Serumprobe.

A) Serumprobe enthält 50 μL Serum, 10 μL der alkoholischen Spinprobenlösung mit einer Konzentration von $0,5*10^{-2}$ mol/L, Spinprobenendkonzentration $8,33*10^{-4}$ mol/L
B) Serumprobe enthält 50 μL Serum, 12 μL der alkoholischen Spinprobenlösung mit einer Konzentration von $0,8*10^{-2}$ mol/L, Spinprobenendkonzentration $1,55*10^{-3}$ mol/L
C) Serumprobe enthält 50 μL Serum, 14 μL der alkoholischen Spinprobenlösung mit einer Konzentration von $1,1*10^{-2}$ mol/L, Spinprobenendkonzentration $2,41*10^{-3}$ mol/L [110] ... [529]: Study codes der Patienten.

**Fig. 3** zeigt bevorzugte Konzentrationen der Spinsonde (16 Doxilstearinsäure) und des polaren Reagenzes (Ethylalkohol).

## Patentansprüche

1. Verfahren zur ESR-spektroskopischen Untersuchung einer albuminhaltigen Probe unter Verwendung einer Spinsonde,
**dadurch gekennzeichnet, daß**
Veränderungen der Transporteigenschaften des Albumins in einer albuminhaltigen Probe bestimmt werden, indem in der zu untersuchenden Probe gezielte Konformationsänderungen des Albuminmoleküls induziert werden, indem aliquoten Teilen der Probe mindestens drei unterschiedliche Konzentrationen einer mit dem Albumin bindenden Spinsonde und zusätzlich mindestens drei unterschiedliche Konzentrationen eines polaren Reagenzes zugesetzt werden, anhand der ESR-Spektren der mit Spinsonde und polarem Reagenz versetzten aliquoten Teile der Grad der Veränderung der Bindungsparameter der Spinsonde an spezifische Bindungsstellen des Albumins in Abhängigkeit von der Spinsondenkonzentration und der Konzentration an polarem Reagenz mittels Computersimulation der ESR-Spektren bestimmt wird und die Veränderungen der Transporteigenschaften des Albumins aus den Veränderungen der Werte der Bindungsparameter der Spinsonde für die durch die unterschiedlichen Konzentrationen an Spinsonde und polarem Reagenz induzierten Konformationszustände des Albumins berechnet werden, wobei die zuzusetzenden Konzentrationen an Spinsonde so ausgewählt werden, daß der Mittelwert des Verhältnisses der Konzentration der Spinsonde zur Konzentration des Albumins $2,5 \pm 0,5$ beträgt und ausgehend von diesem Mittelwert mindestens zwei zusätzliche Konzentrationen ausgewählt werden, deren Abweichung von diesem Mittelwert nicht geringer als 1,0 ist, und die zuzusetzenden Konzentrationen an polarem Reagenz so ausgewählt werden, daß der Mittelwert der Endkonzentration des polaren Reagenzes $(0,6 \pm 0,25) \times cp$ beträgt wobei Cp die kritische Konzentration des polaren Reagenzes darstellt, dessen Überschreitung zur Denaturierung des Albumins führt, und ausgehend von diesem Mittelwert mindestens zwei zusätzliche Konzentrationen an polarem Reagenz ausgewählt werden, deren Abweichung von diesem Mittelwert mindestens 15% beträgt, wobei die Konzentrationen an Spinsonde und polarem Reagenz, die den jeweiligen aliquoten Teilen der Probe zugesetzt werden, innerhalb der vorstehend definierten Konzentrationsbereiche so gewählt werden, daß mindestens in einem aliquoten Teil eine geringe Sondenkonzentration und eine geringe Konzentration an polarem Reagenz, in mindestens einem aliquoten Teil eine mittlere Konzentration an polarem Reagenz und eine mittlere Konzentration an Spinsonde und in mindestens einem aliquoten Teil eine hohe Sondenkonzentration und eine hohe Konzentration an polarem Reagenz vorhanden sind.

2. Verfahren nach Anspruch 1,
**dadurch gekennzeichnet, daß**
zusätzlich noch weitere Konzentrationskombinationen an Spinsonde und polarem Reagenz so gewählt werden, daß. in mindestens einem aliquoten Teil eine hohe Sondenkonzentration und eine geringe Konzentration an polarem Reagenz vorhanden ist.

3. Verfahren nach Anspruch 2,
   **dadurch gekennzeichnet, daß**
   zusätzlich noch weitere Konzentrationskombinationen an Spinsonde und polarem Reagenz so gewählt werden, daß in mindestens einem aliquoten Teil eine geringe Sondenkonzentration und eine hohe Konzentration an polarem Reagenz vorhanden ist.

4. Verfahren nach Anspruch 1,
   **dadurch gekennzeichnet, daß**
   als albuminhaltige Probe eine Blutprobe oder eine Arzneimittelprobe eingesetzt wird.

5. Verfahren nach Anspruch 1,
   **dadurch gekennzeichnet, daß**
   als Spinsonde spinmarkierte Fettsäuren, besonders bevorzugt Doxylstearinsäuren, eingesetzt werden.

6. Verfahren nach Anspruch 1,
   **dadurch gekennzeichnet, daß**
   als polares Reagenz Alkohol oder DMSO eingesetzt wird, vorzugsweise Ethylalkohol.

7. Verfahren nach Anspruch 1,
   **dadurch gekennzeichnet, daß**
   die Parameter der Spinsondenbindung von Aliquoten einer Blutprobe bei unterschiedlichen Temperaturen von 15 bis 45°C und/oder bei unterschiedlichen pH-Werten von 7,5 bis 3,5 bestimmt werden.

8. Verfahren nach Anspruch 1,
   **dadurch gekennzeichnet, daß** die Bindungsparameter des Albumins mittels der mathematischen Methode der Regression des Verhältnisses der Bindungsparameter der Spinsonden in den Aliquoten in Abhängigkeit von der Veränderung der Konzentrationen der Spinsonde und der Konzetrationen des polaren Reagenzes bestimmt werden und aus diesen Bindungsparametern die Veränderung der Transporteigenschaften des Albumins berechnet wird.

9. Verfahren nach Anspruch 1,
   **dadurch gekennzeichnet, daß**
   es zur Diagnose und/oder Überwachung physiologischer oder pathologischer Veränderungen im menschlichen oder tierischen Körper angewandt wird, indem aus den ermittelten Bindungsparametern des Albumins je nach zu diagnostizierender physiologischer oder pathologischer Veränderung spezifische Parameter, vorzugsweise die Verhältnisse der relativen Spinsondenkonzentrationen C1, C2, C3 in den Fettsäurebindungsstellen zwischen den Aliquoten bestimmt und diese mit den .mittels Diskriminierungsfunktion ermittelten cut-off-Werten von Referenzproben verglichen werden.

10. Verfahren nach Anspruch 9,
    **dadurch gekennzeichnet, daß**
    es zur Diagnose und/oder Überwachung onkologischer Erkrankungen angewandt wird.

11. Verfahren nach Anspruch 10,
    **dadurch gekennzeichnet; daß**
    einer oder mehrere der Parameter $D_i$ gemäß Tabelle 5, die Gegenstand dieses Anspruches ist, ermittelt werden, wobei eine onkologische Erkrankung vorliegt, wenn einer der Parameter $D_i > 1$ ist.

12. Verfahren nach Anspruch 1,
    **dadurch gekennzeichnet, daß**
    es zur Bestimmung und Kontrolle der Qualität von albuminhaltigen Präparaten, vorzugsweise Blut- oder Plasmapräparaten, angewandt wird, indem die gemäß Anspruch 1 bestimmten Veränderungen der Transporteigenschaften des Albumins ins Verhältnis gesetzt werden zu den Transporteigenschaften des Ausgangsmaterials und/oder des nativen Serumalbumins gesunder Probanden.

13. Testkit, der zur Durchführung des Verfahrens nach den Ansprüchen 1 bis 12 geeignet ist und dafür

in Probencontainern exakt dosierte Konzentrationen an Spinsonde und polarem Reagenz umfaßt, wobei mindestens drei Probencontainer mit jeweils untereinander unterschiedlichen Konzentrationen an Spinsonde und zusätzlich mit jeweils untereinander unterschiedlichen Konzentrationen an polarem Reagenz Bestandteile des Testkits sind, und wobei

die Konzentrationen an Spinsonde und polarem Reagenz, die den jeweiligen aliquoten Teilen der Probe zugesetzt werden, so gewählt sind, daß mindestens für einen aliquoten Teil eine geringe Sondenkonzentration und eine geringe Konzentration an polarem Reagenz, für mindestens einen aliquoten Teil eine mittlere Konzentration an polarem Reagenz und eine mittlere Konzentration an Spinsonde und für mindestens einen aliquoten Teil eine hohe Sondenkonzentration und eine hohe Konzentration an polarem Reagenz vorhanden sind.

14. Testkit nach Anspruch 13;
**dadurch gekennzeichnet, daß**
er eine Mikrotiterplatte umfaßt, die in mindestens drei Kavitäten fixierte, stabilisierte und exakt dosierte unterschiedliche Konzentrationen an Spinsonde und polarem Reagenz enthalten.

15. Verfahren zur ESR-spektroskopischen Untersuchung nach Anspruch 1,
**dadurch gekennzeichnet, daß**
zur Durchführung des Verfahrens ein ESR-Spektrometer eingesetzt wird, bestehend aus einem geschirmten Kompakt-Elektromagneten mit Hall-Stabilisierungssystem (2), einem Meßresonator (3), der mit einer UHF-Einheit (5) mit geregeltem Haupt-Oszillator zur Frequenzabstimmung in einem ersten Bereich von 200 bis 400 MHz der zentralen Frequenz von 9,45 ± 0,5 GHz gekoppelt ist, einer Gerätesteuerund einer Signalregistriereinheit (9) und einem System zur Thermosstatregelung (7) der Untersuchungsproben, wobei zur Regelung des Meßresonators (3) bezüglich der Kompensation des Frequenzunterschieds bei der Spektrenregistrierung der Aliquoten einer Untersuchungsprobe der Meßresonator (3) mit einem weiteren Steuergerät für die Abstimmung der Resonanzfrequenz in einem zweiten Bereich von 10 bis 50 MHz mittels einer Resonatorhohlraumvolumenvariation gekoppelt ist.

16. Verfahren nach Anspruch 15,
**dadurch gekennzeichnet, daß**
das Thermostatregelungssystem (7) des eingesetzten ESR-Spektrometers eine zusätzliche Regelungsschleife zur Präzisionserhöhung der Probentemperaturstabilisierung durch Minimierung der Gradienten innerhalb des Resonatorschachtes durch elektromagnetische Selbstaufheizung enthält, die durch Regelung der Stromzufuhr zum Elektromagneten dessen Selbstaufheizung während der Unterbrechungen der Spektrenabtastung steuert, dessen Wärmeabstrahlung den Resonator erwärmt.

17. Verfahren nach den Ansprüchen 15 und 16,
**dadurch gekennzeichnet, daß** in dem eingesetzten ESR-Spektrometer der Resonatorkörper (3) mit einem Temperatursensor (4) zur Regelung der elektromagnetischen Selbstheizung des Elektromagneten verbunden ist, welcher die Aufheizung des Resonators bis zur Probentemperatur vornimmt.

**Claims**

1. A method for the ESR-spectroscopic investigation of an albumin-containing sample using a spin probe,
**characterized in that**
changes in the transport properties of albumin in an albumin-containing sample are determined **in that** specific conformational changes of the albumin molecule are induced in the sample under investigation by adding at least three different concentrations of a spin probe binding to albumin and, in addition, at least three different concentrations of a polar reagent to aliquots of the sample, the degree of change in the parameters of binding of the spin probe to specific binding sites of the albumin as a function of the spin probe concentration and the concentration of polar reagent is determined with reference to the ESR spectra of the aliquots added with spin probe and polar reagent, using a computer simulation of the ESR spectra, and the change in the transport properties of the albumin is calculated from the changes of the values of the binding parameters of the spin probe for the conformational states of the albumin induced by the different concentrations of spin probe and polar reagent, the concentrations of spin probe to be added being selected in such a way that the mean value of the ratio of spin probe concentration to albumin concentration is $2.5 \pm 0.5$ and, starting from this mean value, at least two additional concentrations are selected whose deviation from this mean value is no less than 1.0, and the concentrations of polar reagent to be added are selected in such a way that the mean value of the final concentration of polar reagent is $(0.6 \pm 0.25)x$

Cp, wherein Cp represents the critical concentration of polar. reagent, surpassing of which would result in denaturing of the albumin, and, starting from this mean value, at least two additional concentrations of polar reagent are selected, whose deviation from this mean value is at least 15%, the concentrations of spin probe and polar reagent added to the respective aliquots of the sample being selected within the above-defined concentration ranges in such a way that at least one aliquot includes a low concentration of probe and a low concentration of polar reagent, at least one aliquot includes a medium concentration of polar reagent and a medium concentration of spin probe, and at least one aliquot includes a high concentration of probe and a high concentration of polar reagent.

2. The method according to claim 1,
**characterized in that**
in addition, further combinations of concentrations of spin probe and polar reagent are selected in such a way that at least one aliquot includes a high concentration of probe and a low concentration of polar reagent.

3. The method according to claim 2,
**characterized in that**
in addition, further combinations of concentrations of spin probe and polar reagent are selected in such a way that at least one aliquot includes a low concentration of probe and a high concentration of polar reagent.

4. The method according to claim 1,
**characterized in that**
a blood sample or a sample of a drug is employed as albumin-containing sample.

5. The method according to claim 1,
**characterized in that**
spin-labelled fatty acids, most preferably doxylstearic acids are used as spin probe.

6. The method according to claim 1,
**characterized in that**
an alcohol or DMSO is used as polar reagent, preferably ethyl alcohol.

7. The method according to claim 1,
**characterized in that**
the parameters of spin probe binding of aliquots of a blood sample are determined at different temperatures of from 15 to 45°C and/or at different pH values of from 7.5 to 3.5.

8. The method according to claim 1,
**characterized in that**
the albumin binding parameters are determined using the mathematical method of regression of the ratio of the binding parameters of the spin probes in the aliquots as a function of the changes in the concentrations of spin probe and the concentrations of polar reagent, and the change in the transport properties of the albumin is calculated using these binding parameters.

9. The method according to claim 1,
**characterized in that**
the method is used for diagnosing and/or monitoring physiological or pathological changes in a human or animal body in such a way that, depending on the physiological or pathological change to be diagnosed, the ratios of the relative spin probe concentrations C1, C2, C3 in the fatty acid binding sites between the aliquots are preferably determined from the albumin binding parameters found, and these ratios are compared with the cut-off values of reference samples determined using discrimination functions.

10. The method according to claim 9,
**characterized in that**
the method is used for diagnosing and/or monitoring oncologic diseases.

11. The method according to claim 10,
**characterized in that**
one or more of parameters $D_i$ are determined according to Table 5, said Table 5 being a subject matter of the present claim, an oncologic disease being present if one of the parameters $D_i > 1$.

12. The method according to claim 1,
    **characterized in that**
    the method is used for determining and monitoring the quality of albumin-containing preparations, preferably blood or plasma preparations, by comparing the changes of the albumin transport properties determined according to claim 1 with the transport properties of the starting material and/or native serum albumin from healthy subjects.

13. A test kit which is qualified for performing the method according to claims 1 to 12, and which comprises in sample containers precisely dosed concentrations of spin probe and polar reagent, at least three sample containers including mutually different concentrations of spin probe and, in addition, mutually different concentrations of polar reagent being components of said test kit and whereby the concentrations of spin probe and polar reagent added to the respective aliquots of the sample being selected in such a way that at least one aliquot includes a low concentration of probe and a low concentration of polar reagent, at least one aliquot includes a medium concentration of polar reagent and a medium concentration of spin probe, and at least one aliquot includes a high concentration of probe and a high concentration of polar reagent.

14. The test kit according to claim 13,
    **characterized in that**
    the kit comprises a microtiter plate which includes fixed, stabilized and precisely dosed different concentrations of spin probe and polar reagent in at least three cavities.

15. The method of ESR-spectroscopic investigation according to claim 1,
    **characterized in that**
    an ESR spectrometer is used to perform the method, which consists of a shielded compact electromagnet with Hall stabilization system (2), a measuring resonator (3), which is coupled to a UHF unit (5) including a controlled main oscillator for tuning the frequency in a first range of from 200 to 400 MHz of the central frequency of $9.45 \pm 0.5$ GHz, a device control and signal registration unit (9), and a system of thermostat control (7) for the samples to be investigated, whereby the measuring resonator (3), in order to control the measuring resonator (3) with respect to compensation of the frequency difference during recording spectra of aliquots of a sample to be investigated, being coupled with another control device to tune the resonance frequency in a second range of from 10 to 50 MHz, using resonator cavity volume variation.

16. The method according to claim 15,
    **characterized in that**
    the thermostat control system (7) of the ESR spectrometer used includes an additional control loop to increase the precision of sample temperature stabilization by minimizing the gradients within the resonator chamber by electromagnetic self-heating, which control loop, by controlling the power supply to the electromagnet, controls self-heating thereof during the interruptions in spectrum recording, the heat radiation of which heating the resonator.

17. The method according to claims 15 and 16,
    **characterized in that**
    the resonator body (3) in the ESR spectrometer used is connected to a temperature sensor (4) to control electromagnetic self-heating of the electromagnet, which self-heating effects heating of the resonator up to the sample temperature.

**Revendications**

1. Procédé d'analyse spectroscopique RSE d'un échantillon contenant de l'albumine en utilisant une sonde de spin,
   **caractérisé en ce**
   **qu'**on détermine les modifications des propriétés de transport de l'albumine dans un échantillon contenant de l'albumine, de la manière suivante :

   - on induit dans l'échantillon à analyser des modifications de conformation ciblées de la molécule d'albumine en ajoutant à des parties aliquotes de l'échantillon au moins trois concentrations différentes d'une sonde spin se liant à l'albumine et encore au moins trois concentrations différentes d'un réactif polaire,
   - on détermine, à partir des spectres RSE des parties aliquotes mélangées à la sonde de spin et au réactif polaire, le degré de modification des paramètres de liaison de la sonde de spin à des sites de liaison spécifiques de l'albumine en fonction de la concentration de la sonde de spin et de la concentration en réactif polaire par simulation sur ordinateur des spectres RSE et

- on calcule les modifications des propriétés de transport de l'albumine à partir des modifications des valeurs des paramètres de liaison de la sonde de spin pour les états de conformation de l'albumine induits par les différentes concentrations de sonde de spin et de réactif polaire,

dans lequel on sélectionne les concentrations de sonde de spin à ajouter de telle sorte que la valeur moyenne du rapport de concentration de la sonde de spin à la concentration de l'albumine soit de $2,5 \pm 0,5$, on sélectionne en partant de cette valeur moyenne deux concentrations supplémentaires, dont l'écart vis à vis de cette valeur moyenne n'est pas inférieur à 1,0, et on sélectionne les concentrations de réactif polaire à ajouter de telle sorte que la concentration finale du réactif polaire soit de $(0,6 \pm 0,25) \cdot Cp$, Cp représentant la concentration critique du réactif polaire, dont le dépassement provoque la dénaturation de l'albumine, puis on sélectionne en partant de cette valeur moyenne au moins deux concentrations supplémentaires de réactif polaire, dont l'écart vis à vis de cette valeur moyenne est d'au moins 15 %, et dans lequel on sélectionne les concentrations de sonde de spin et de réactif polaire ajoutées aux parties aliquotes respectives de l'échantillon dans les plages de concentration définies précédemment, de façon à avoir au moins dans une partie aliquote de l'échantillon une faible concentration en sonde et une faible concentration en réactif polaire, au moins dans une partie aliquote une concentration moyenne de sonde et une concentration moyenne de réactif polaire et au moins dans une partie aliquote une concentration élevée de sonde et une concentration élevée de réactif polaire.

2. Procédé selon la revendication 1,
   **caractérisé en ce**
   **qu'**on sélectionne en complément encore d'autres combinaisons de concentration en sonde de spin et en réactif polaire, de façon à obtenir dans au moins une partie aliquote une concentration élevée en sonde et une concentration faible en réactif polaire.

3. Procédé selon la revendication 2,
   **caractérisé en ce**
   **qu'**on sélectionne en complément encore d'autres combinaisons de concentration en sonde de spin et en réactif polaire, de façon à obtenir dans au moins une partie aliquote une concentration faible en sonde et une concentration élevée en réactif polaire.

4. Procédé selon la revendication 1,
   **caractérisé en ce**
   **qu'**en tant qu'échantillon contenant de l'albumine, on utilise un échantillon de sang ou un échantillon de médicament.

5. Procédé selon la revendication 1,
   **caractérisé en ce**
   **qu'**en tant que sonde de spin, on utilise des acides gras, préférentiellement des acides doxylstéariques marqués en spin.

6. Procédé selon la revendication 1,
   **caractérisé en ce**
   **qu'**en tant que réactif polaire, on utilise de l'alcool ou du DMSO, de préférence de l'alcool éthylique.

7. Procédé selon la revendication 1,
   **caractérisé en ce**
   **qu'**on détermine les paramètres de liaison à la sonde de spin des aliquotes d'un échantillon de sang à différentes températures de 15 à 45°C et/ou à différents pH de 7,5 à 3,5:

8. Procédé selon la revendication 1,
   **caractérisé en ce**
   **qu'**on détermine les paramètres de liaison de l'albumine au moyen d'une méthode mathématique de régression du rapport des paramètres de liaison des sondes de spin dans les aliquotes en fonction de la modification des concentrations de la sonde de spin et des concentrations du réactif polaire et on calcule à partir de ces paramètres de liaison la modification des propriétés de transport de l'albumine.

**9.** Procédé selon la revendication 1,
**caractérisé en ce**
**qu'**on l'utilise pour le diagnostic et/ou la surveillance des modifications physiologiques ou pathologiques dans le corps humain ou animal, en déterminant, à partir des paramètres de liaison de l'albumine recherchés, les paramètres spécifiques, suivant la modification physiologique ou pathologique à diagnostiquer, de préférence les rapports des concentrations relatives des sondes de spin C1, C2, C3 dans les sites de liaison de l'acide gras entre les aliquotes et qu'on compare ceux-ci avec les valeurs limites des échantillons de référence déterminées au moyen d'une fonction de discrimination.

**10.** Procédé selon la revendication 9,
**caractérisé en ce**
**qu'**on l'utilise pour le diagnostic et/ou la surveillance des maladies oncologiques.

**11.** Procédé selon la revendication 10,
**caractérisé en ce**
**qu'**on recherche un ou plusieurs des paramètres $D_i$, selon le tableau 5, qui est l'objet de cette revendication, une maladie oncologique étant présent dans le cas où un des paramètres $D_i > 1$.

**12.** Procédé selon la revendication 1,
**caractérisé en ce**
**qu'**on l'utilise pour déterminer et contrôler la qualité des préparations contenant de l'albumine, de préférence des préparations contenant de sang ou du plasma, en mettant en rapport les modifications déterminées selon la revendication 1 des propriétés de transport de l'albumine avec les propriétés de transport de la matière initiale et/ou de la sérumalbumine native de sujets sains.

**13.** Kit d'essai approprié pour réaliser le procédé selon les revendications 1 à 12, et qui contient à cet effet dans des récipients d'échantillon des concentrations en sonde de spin et en réactif polaire dosées exactement, qui comporte au moins trois récipients d'échantillon contenant chacun différentes concentrations de sonde de spin et aussi différentes concentrations de réactif polaire, dans lequel on sélectionne les concentrations de sonde de spin et de réactif polaire ajoutées aux parties aliquotes respectives de l'échantillon, de manière à obtenir au moins pour une partie aliquote une faible concentration de sonde et une faible concentration de réactif polaire, pour au moins une partie aliquote une concentration moyenne de sonde et une concentration moyenne de réactif polaire et pour au moins une partie aliquote une concentration élevée de sonde et une concentration élevée de réactif polaire.

**14.** Kit d'essai selon la revendication 13,
**caractérisé en ce**
**qu'**il comprend une plaque de microtitration, qui comporte au moins trois cavités contenant des concentrations différentes de sonde de spin et de réactif polaire fixées, stabilisées et dosées exactement.

**15.** Procédé d'analyse spectroscopique RSE selon la revendication 1,
**caractérisé en ce**
**qu'**on utilise un spectromètre RSE pour réaliser la méthode, qui est composé d'un électro-aimant compact doté d'un système de stabilisation de Hall (2), d'un résonateur de mesure (3) qui est couplé à une unité UHF (5) dotée d'un oscillateur principal asservi destiné à la syntonisation des fréquences dans une première gamme de 200 à 400 MHz, de la fréquence moyenne de $9{,}45 \pm 0{,}5$ GHz, d'une unité de commande et d'une unité d'enregistrement de signal (9) et d'un système de régulation thermostatique (7) des échantillons à analyser, dans lequel, pour asservir le résonateur de mesure (3) à une compensation de la différence de fréquence produite au cours de l'enregistrement des spectres des aliquotes d'un échantillon à analyser, le résonateur de mesure (3) est couplé à un autre organe destiné à accorder la fréquence de résonance dans une seconde gamme de 10 à 50 MHz par une variation de volume de la cavité du résonateur.

**16.** Procédé selon la revendication 15,
**caractérisé en ce que**
le système de régulation thermostatique (7) du spectromètre RSE utilisé comporte une boucle de régulation complémentaire destinée à augmenter la précision de la stabilisation de la température de l'échantillon en minimisant les gradients à l'intérieur de la cavité du résonateur produits par autochauffage électromagnétique, qui contrôle l'autochauffage de l'électroaimant par régulation de l'alimentation électrique vers l'électroaimant, pendant les interruptions de l'exploration des spectres, dont le rayonnement thermique chauffe le résonateur.

17. Procédé selon les revendications 15 et 16,
    **caractérisé en ce que**,
    dans le spectromètre RSE utilisé, le corps du résonateur (3) est connecté à un capteur de température (4) destiné à la régulation de l'autochauffage électromagnétique de l'électroaimant, qui effectue le chauffage du résonateur jusqu'à atteindre la température de l'échantillon.

**Fig. 1**

**C1**
rel. Einh.

Relative Konzentration der Spinprobe in Bindungsstelle 1

**C2**
rel. Einh.

Relative Konzentration der Spinprobe in Bindungsstelle 2

**C3**
rel. Einh.

Relative Konzentration der Spinprobe in Bindungsstelle 3

Patienten ohne maligne Tumore          Patienten mit Krebs

# Fig. 2

**Fig. 3**